# EUROPEAN PATENT APPLICATION

(11) **EP 2 692 760 A1**
(43) Date of publication of application: **05.02.2014**
(21) Application number: 12762740.4
(22) Date of filing: 30.03.2012
(51) Int. Cl.: C08G 61/12, C08K 3/04, C08L 65/00, H01L 51/42

(54) **BLOCK COPOLYMER AND PHOTOELECTRIC CONVERSION ELEMENT**

(30) Priority: 31.03.2011 JP 2011080310; 26.08.2011 JP 2011184629
(71) Applicant: Kuraray Co., Ltd., Okayama 710-0801 (JP)
(72) Inventor: IZAWA, Takafumi, Kurashiki-shi Okayama 710-0801 (JP); SHIBUYA, Hiromasa, Kurashiki-shi Okayama 710-0801 (JP); SUGIOKA, Takashi, Kurashiki-shi Okayama 710-0801 (JP); INAGAKI, Takuya, Kurashiki-shi Okayama 710-0801 (JP); MORIHARA, Yasushi, Kurashiki-shi Okayama 710-0801 (JP); NAKAHARA, Atsuhiro, Kurashiki-shi Okayama 710-0801 (JP); FUJITA, Akio, Kurashiki-shi Okayama 710-0801 (JP); OGI, Hiroyuki, Kurashiki-shi Okayama 710-0801 (JP)
(74) Representative: Müller-Boré & Partner Patentanwälte PartG mbB
(86) International application number: PCT/JP2012/058617
(87) International publication number: WO 2012/133793

(57) **Abstract**

Provide are: a conjugated block copolymer capable of increasing the amount of optical absorption by a photoelectric conversion active layer and controlling the morphology thereof and capable of achieving excellent photoelectric conversion efficiency; and a photoelectric conversion element comprising a composition including an electron accepting material and this kind of conjugated block polymer. A π-electron conjugated block copolymer comprising: a polymer block (A) which involving a monomer unit having at least one heteroaryl skeleton selected from the group consisting of a fused π-conjugated skeleton, a fluorene, a carbazole, a dibenzosilole and a dibenzogermole containing at least one thiophene ring in a part of a chemical structure thereof; and a polymer block (B) involving a monomer unit of a thiophene-2,5-diyl group having a substituent at least at a 3-position thereof.

## Description

### Technical Field

The present invention relates to a novel π-electron conjugated block copolymer, and to a photoelectric conversion element made of the copolymer.

### Background Art

Organic thin film solar cells which are produced by coating using a polymer material that is soluble in solvent has attracted much attention, because they can be produced at low cost when compared with inorganic solar cells which are mainstream solar cells that have been made of polycrystalline silicon, amorphous silicon, compound semiconductor, etc.

The organic thin film solar cell, generally has a photoelectric conversion active layer which has a bulk heterojunction structure formed with a mixture of a conjugated polymer and an electron accepting material. As a specific example, there is an organic thin film solar cell having a photoelectric conversion active layer including a mixture of poly(3-hexylthiophene) which is a conjugated polymer, and [6,6]-phenyl C₆₁ butyric acid methyl ester (PCBM), or a fullerene derivative which is an electron accepting material, refer to Non-Patent Document 1 below.

In the bulk heterojunction structure, incident light entering from the transparent electrode is absorbed by an electron accepting material and/or a conjugated polymer to generate an exciton which is a bound state of an electron and a hole. The generated exciton moves to the heterojunction interface where the electron accepting material abuts on the conjugated polymer, to charge-separate into electrons and holes. Holes and electrons are then each transported through the conjugated polymer phase and the electron accepting material phase, and are then taken out from an electrode. Therefore, in order to improve photoelectric conversion efficiency of the organic thin film solar cells, the key point is to increase an amount of optical absorption of the photoelectric conversion active layer and to control the morphology of a bulk heterojunction structure which is formed through phase separation of the conjugated polymer and the electron accepting material.

The poly(3-hexylthiophene) has optical absorption in the visible light region. However, many conjugated polymers having absorption at a long wavelength region (up to a near infrared region) have already been proposed (see Non-Patent Documents 2 and 3, listed below). Hereinafter the conjugated polymers can be referred to as a narrow band gap polymer. However, the narrow band gap polymers have poor optical absorption in the visible light region, so that a very expensive C₇₀ fullerene derivative that has optical absorption in the visible light region has been used as electron accepting materials, being undesirable.

To solve this problem, a bulk heterojunction type photoelectric conversion active layer has been proposed in which poly(3-hexylthiophene), a conjugated polymer of a narrow band gap polymer and an electron accepting material are mixed (Non-Patent Document 4).

On the other hand, as excellent methods that can control morphology of the electron accepting material and the conjugated polymer, a method using a conjugated block copolymer is proposed. For example, organic thin-film solar cells have been reported in which a diblock copolymer of 3-hexylthiophene and 3-(2-ethylhexyl thiophene) (Non-Patent Document 5), a diblock copolymer of 3-hexylthiophene and 3-(phenoxymethyl)thiophene (Non-Patent Document 6), a diblock copolymer of 3-butylthiophene and 3-octylthiophene (Non-Patent Documents 7 and 8), or a diblock copolymer of 3-hexylthiophene and 3-cyclohexyl thiophene (Non-Patent Document 9) is used as a conjugated block copolymer, and fullerene derivatives are used as electron accepting materials. Further, in order to develop high photoelectric conversion efficiency, an organic thin film solar cell element using the conjugated block copolymer of the narrower band gap polymer has also been reported (Patent Document 1).

### [Prior Art Documents]

### [Patent Document]

[Patent Document 1 Japan Patent Application Publication No. 2008-266459

### [Non-Patent Documents]

[Non-Patent Document 1] Angew., Chem. Int. Ed, 47, p.58 (2008)
[Non-Patent Document 2] Adv. Mater., 22, E6 (2010)
[Non-Patent Document 3] Adv. Mater., 22, p.3839 (2010)
[Non-Patent Document 4] Adv. Funct. Mater. , 20, p.338 (2010)
[Non-Patent Document 5] J. Am. Chem. Soc. , 130, p.7812 (2008)
[Non-Patent Document 6] Organic Electronics, 10, p.1541 (2009)
[Non-Patent Document 7] Macromolecules, 42, p.2317 (2009)
[Non-Patent Document 8] Chem. Mater., 22, p.2020 (2010)
[Non-Patent Document 9] J. Polym. Sci. Part A: Polym. Chem., 48, p.614 (2010)

### Summary of the Invention

### Problems to be solved by the Invention

The organic thin film solar cells using conjugated copolymer blends listed in the prior art documents described above, have difficulty in controlling morphology, etc., so that the photoelectric conversion efficiency thereof remains at about 2.8% at most. The organic thin film solar cells using conjugated block copolymer is considered to control the morphology to some extent, but the percent value of photoelectric conversion efficiency remains only 2 to 3 percent. The present invention was made to solve the problems mentioned above, to provide a conjugated block copolymer capable of controlling the morphology, increasing optical absorption in a photoelectric conversion active layer, and developing excellent photoelectric conversion efficiency, and to provide a photoelectric conversion element composed of a composition comprising the conjugated block polymer and an electron accepting material.

### Means for Solving the Problems

The present invention which was made to achieve the objects described above is a π-electron conjugated block copolymer comprises:
a polymer block (A) which involving a monomer unit having at least one heteroaryl skeleton selected from the group consisting of a fused π-conjugated skeleton, a fluorene, a carbazole, a dibenzosilole and a dibenzogermole containing at least one thiophene ring in a part of a chemical structure thereof; and
a polymer block (B) involving a monomer unit of a thiophene-2,5-diyl group having a substituent at least at a 3-position thereof.

The present invention is the π-electron conjugated block copolymer, wherein the polymer block (A) includes a monomer unit of -a-b-, -a- has any one of groups represented by the following formulas (1) - (6), 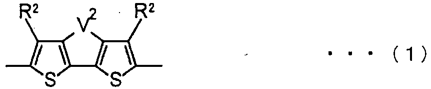 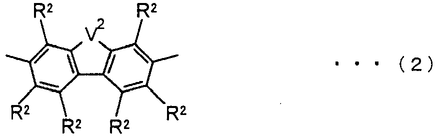 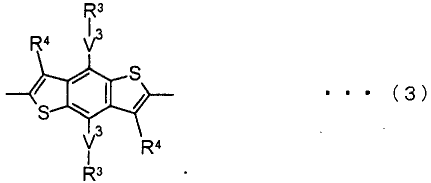 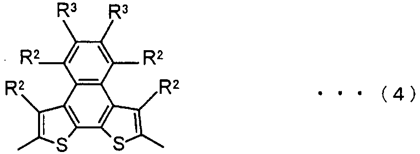 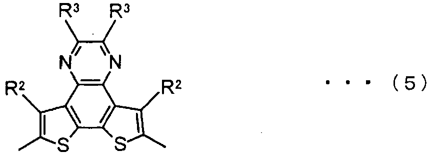 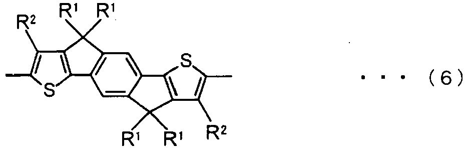 and -b- is a monomer unit having any one of groups represented by the formulas (7) - (17).

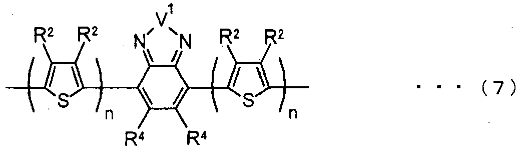

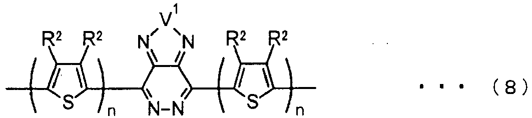

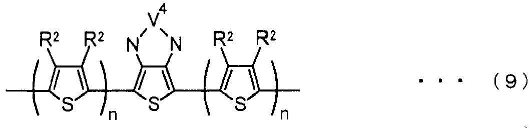

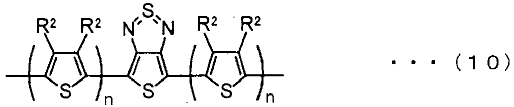

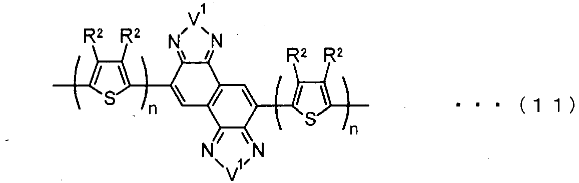

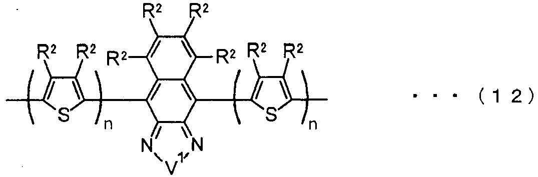

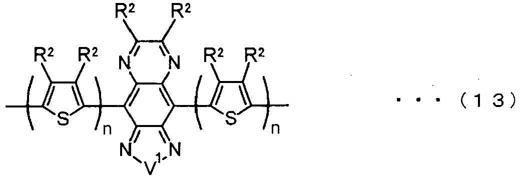

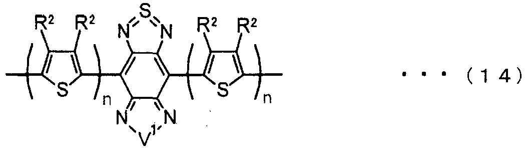

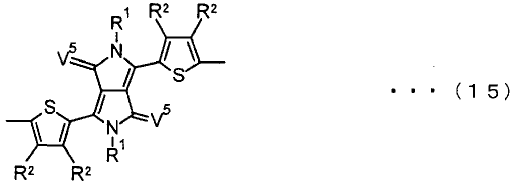

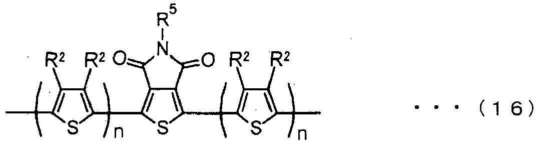

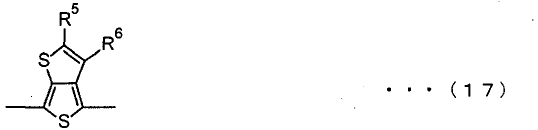

In the above formula (1) - (17), V¹ is a nitrogen (-NR¹-), oxygen (-O-), or sulfur (-S-); V² is a carbon (-CR¹₂-), nitrogen (-NR¹-), silicon (-SiR¹₂-) or germanium (-GeR¹₂-); V³ is an aryl or heteroaryl group represented by -(Ar)ₙ-; V⁴ is a nitrogen (-NR¹-), oxygen (-O-), or -CR²=CR²-; V⁵ is an oxygen (O) or sulfur (S).

R¹ is an alkyl group having 1-18 carbon atoms which may be each independently substituted; R² is a hydrogen atom or an alkyl group having 1-18 carbon atoms which may be each independently substituted; R³ is an alkoxy group or an alkyl group having 1-18 carbon atoms which may be each independently substituted; R⁴ is a hydrogen atom, a halogen atom, an aryl group or an alkyl group having 1-18 carbon atoms which may be each independently substituted; R⁵ is an aryl group, an alkylcarbonyl group, an alkyloxycarbonyl group or an alkyl group having 1-18 carbon atoms which may be substituted, and R⁶ is a hydrogen atom or a halogen atom. n represents an integer of 0 -3.

The present invention is the π-electron conjugated block copolymer, wherein the monomer unit -a-b- is any one selected from the following formulas (18) - (28).

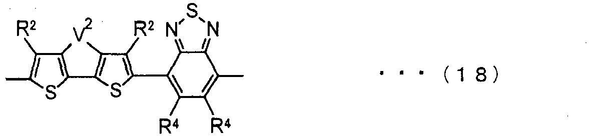

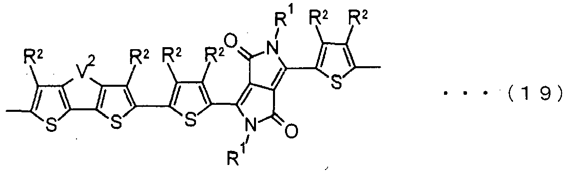

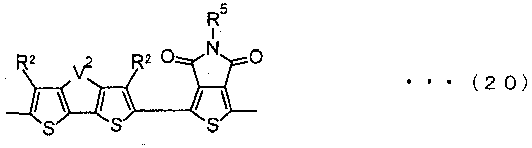

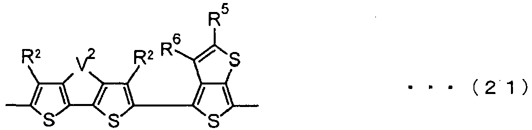

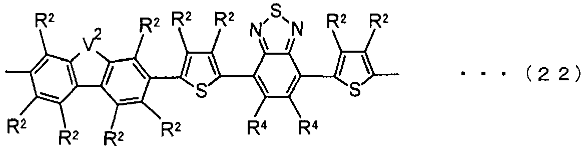

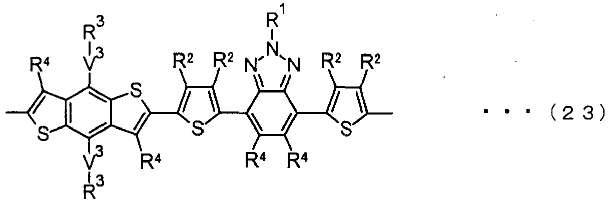

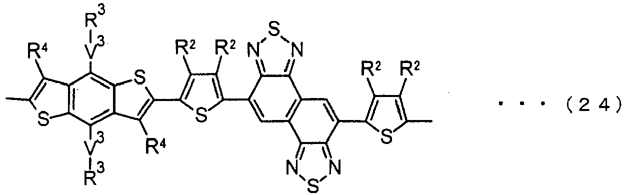

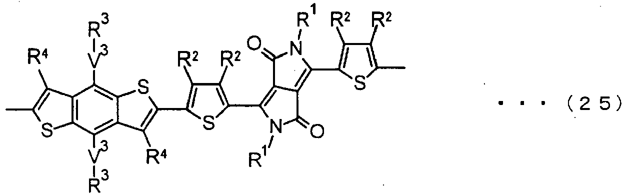

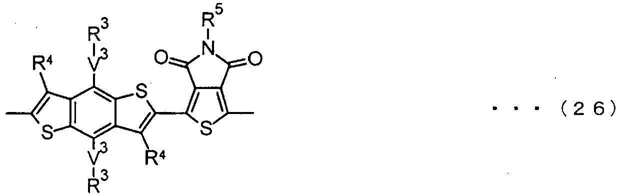

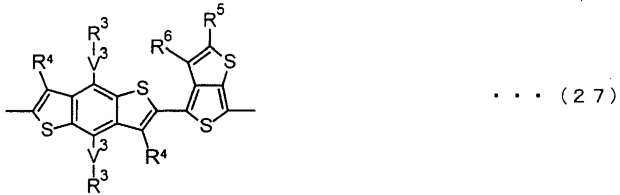

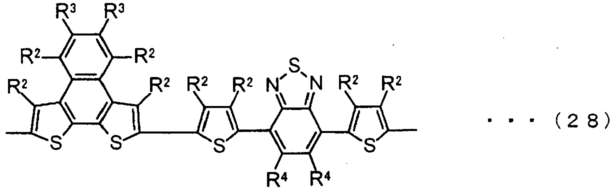

In the formulas (18) - (28), V² is a carbon (-CR¹₂-), nitrogen (-NR¹-), silicon (-SiR¹₂-) or germanium (-GeR¹₂-). V³ is an aryl or heteroaryl group represented by -(Ar)ₙ-.

R¹, R², R³, R⁴, R⁵ and R⁶ are the same meanings as defined above. n represents an integer of 0 - 3.

The present invention is the π-electron conjugated block copolymer, wherein the polymer block (B) includes a monomer unit bonding 2 to 5 of thiophene-2,5-diyl groups having a substituent at least at the 3-position thereof.

The present invention is the π-electron conjugated block copolymer, wherein the polymer block (B) is a random copolymer block having a plural types of thiophene-2,5-diyl groups having a substituent at least at the 3-position thereof.

The present invention is the π-electron conjugated block copolymer, wherein a number average molecular weight thereof is in the range of 1,000 - 200,000 g/mol.

The present invention which was made to achieve the object described above is a composition comprising an electron accepting material and the π-electron conjugated block copolymer described above.

Similarly, the present invention which was made to achieve the object of the present invention is a photoelectric conversion element comprising a layer essentially consisting of the composition described above.

The present invention is the photoelectric conversion element, wherein the electron accepting material is a fullerene or/and a derivative thereof.

### Effects of the Invention

When the present π-electron conjugated block copolymer is used in a photoelectric conversion element together with an electron accepting material, an increase in the current value and a decrease in the resistance can be realized because of an expansion of absorption wavelength on a long wavelength region, and the performance of the element is significantly improved.

### Mode for Carrying Out the Invention

Preferred embodiments for carrying out the present invention will be precisely explained below, but the scope of the present invention is not limited to these embodiments.

The π-electron conjugated block copolymer of the present invention bonding the polymer block (A) and the polymer block (B), and the main chain skeleton of the monomer unit is a π-electron conjugated divalent group. The monomer unit of the polymer block (A) has at least one heteroaryl skeleton selected from the group consisting of a fused π-conjugated skeleton, a fluorene, a carbazole, a dibenzosilole and a dibenzogermole containing at least one thiophene ring in a part of a chemical structure thereof. As an example of the fused π-conjugated skeleton containing at least one thiophene ring in a part of a chemical structure thereof, for example, cyclopentadithiophene, dithienopyrrole, dithienosilole, dithienogermole, benzodithiophene, naphthodithiophene, etc. can be exemplified.

The monomer unit that constitutes the polymer block (A) includes a monomer unit -a-b-, -a- has any group (a group comprising a donor-type unit) represented by the formulas (1) - (6), and -b- has any group (a group comprising a unit having a ring that serves as an acceptor) represented by the formulas (7) - (17). Note that in the formula (3), V³ is a monocyclic or polycyclic aryl group or heteroaryl group (n is an integer of 0-3) represented by -(Ar)ₙ-, and is a portion of the main chain skeleton in the monomer unit. As V³, a thiophene ring is particularly preferable. As -a-, monomer units having any group represented by the formulas (1), (2) and (3) are more preferable. As -b-, monomer units having any group represented by the formulas (7), (11), and (15) - (17) are more preferable.

Further, as specific examples of the monomer unit that constitutes -a-b-, for example, monomer units represented by the formulas (18) - (28) are exemplified. For example, a monomer unit represented by a formula -(1)-(7)- is a formula represented by the formula (18), similarly, -(1)-(15)- is represented by (19), -(1)-(16)- is represented by (20), -(1)-(17)- is represented by (21), -(2)-(7)- is represented by (22), -(3)-(7)- is represented by (23), -(3)-(11)- is represented by (24), -(3)-(15)- is represented by (25), -(3)-(16)- is represented by (26), -(3)-(17)- is represented by (27), and -(4)-(7)- is represented by (28). Note that in the present invention, as long as a polymer has a plurality of certain repeating structures in the polymer, a plurality of bonded heteroaryl structures (or, for example, a monomer unit of -a-b-) comprising a thiophene, a fluorene, a carbazole, a dibenzosilole or a dibenzogermole is also regarded as one of the monomer unit. In other words, as long as the substituent is the same, a complete alternating copolymer block of the monomer unit -a- and the other monomer unit -b- is considered to be a homopolymer block of the monomer unit -a-b-.

In the polymer block (A) of the present invention, the total number of carbon atoms of the ring structure (the carbon numbers on a substituent Rⁿ are excluded) in one type monomer unit including the -a-b- type monomer unit is preferably in the range of 6 - 30.

In order to increase the amount of current, it is desirable that the present π-electron conjugated block copolymer exhibits optical absorption until a long wavelength light as possible. Polymer block (B) of the block copolymer comprising monomer units of thiophene-2,5-diyl group which has a substituent at least at the 3-position, in general, exhibits optical absorption in the visible light region. Accordingly, it is preferable that the polymer block (A) is preferably composed of monomer units which can be absorbed at least on the longer wavelength side than the polymer block (B).

If the polymer block (A) has a high planarity that is hard to form a twisted structure, the polymer absorbs longer wavelength light and has high photoelectric conversion efficiency. From this point of view, the polymer block (A) preferably comprises a monomer unit having at least one heteroaryl skeleton selected from the group consisting of a fused π-conjugated skeleton, a carbazole, and a dibenzogermole containing at least one thiophene ring in a part of the chemical structure thereof, more preferably comprises a monomer unit having at least one fused π-conjugated skeleton containing at least one thiophene ring in a part of the chemical structure thereof.

Preferable specific examples of -a- represented by the formulas (1) - (6) are not particularly limited, but for example, groups represented by the following formulas (29) - (34) are exemplified.

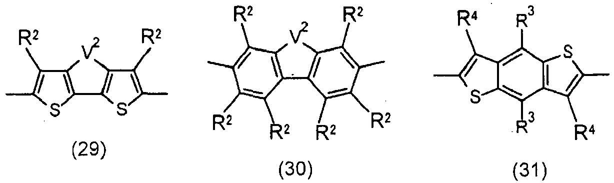

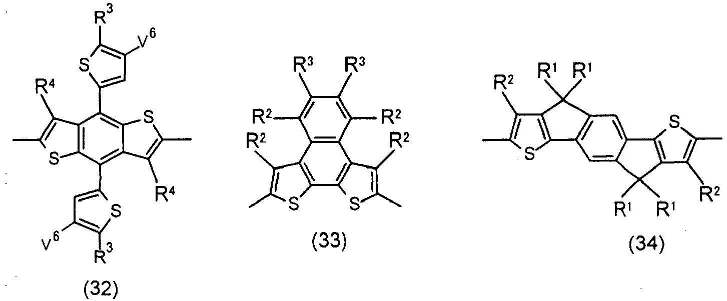

In the formulas, V², R², R³ and R⁴ are the same meanings as defined above, and V⁶ is each independently a hydrogen atom or R³.

Preferable specific examples of -b- represented by the formulas (7) - (17) are not particularly limited, but, for example, groups represented by the following formulas (35) - (40) are exemplified.

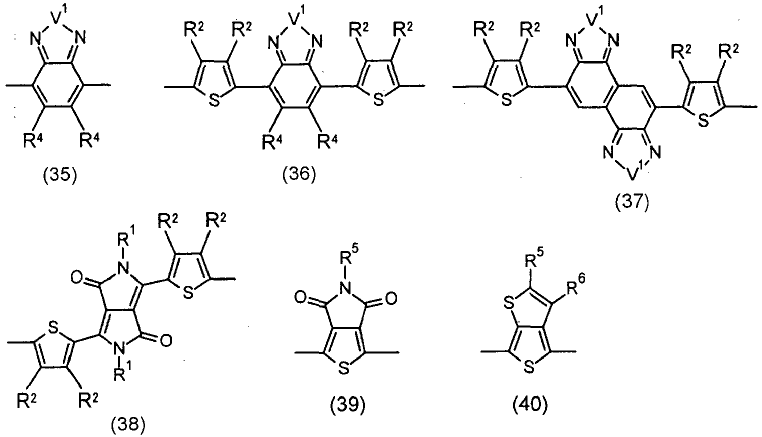

In the formulas, V¹, R², R⁴, R⁵ and R⁶ are the same meanings as defined above.

Further, as a preferred embodiment of -a-b- represented by the formulas (18) - (28), are not particularly limited, but, for example, groups represented by the following formulas (41) - (59) can be exemplified.

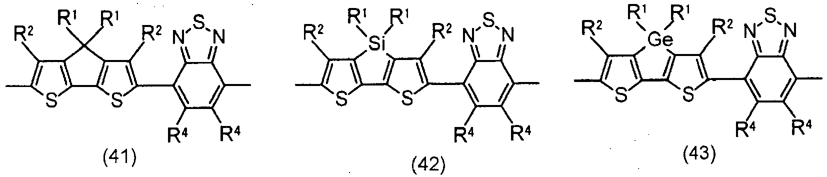

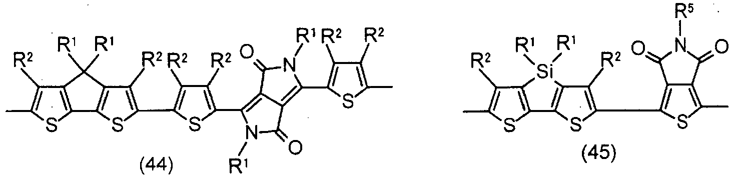

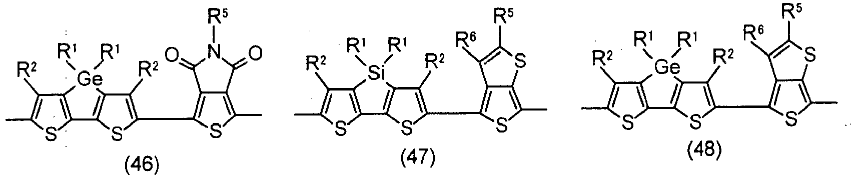

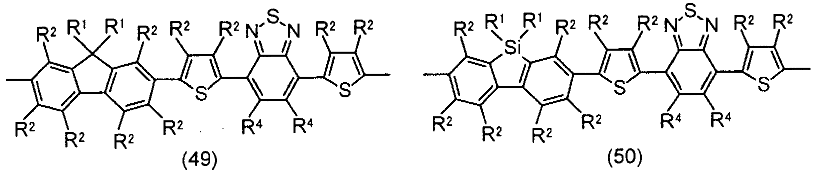

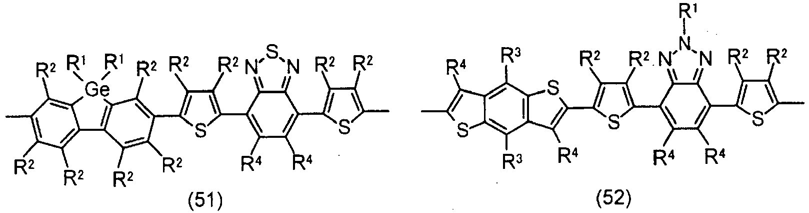

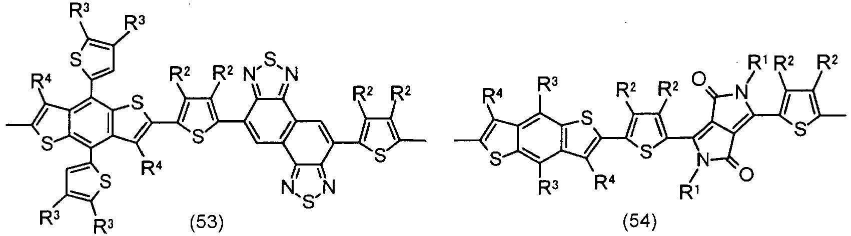

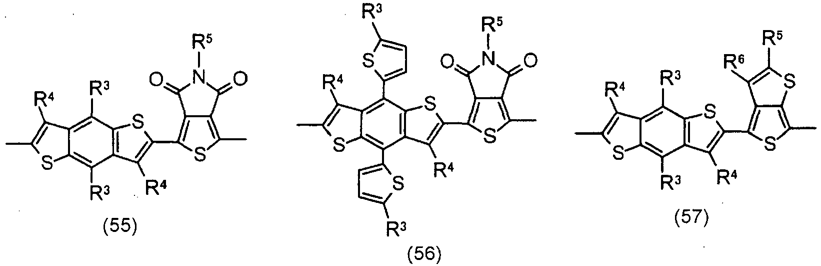

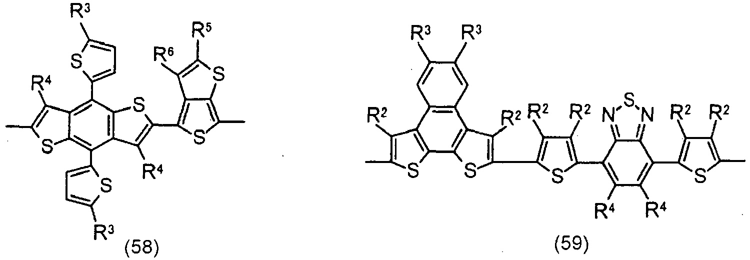

In the formulas, R¹ - R⁶ are the same meanings as defined above.

The polymer block (A) may have a substituent represented by R¹ to R⁶ described above. R¹ is an alkyl group having 1 - 18 carbon atoms which may be each independently substituted; R² is a hydrogen atom or an alkyl group having 1 - 18 carbon atoms which may be each independently substituted; R³ is an alkoxy group or an alkyl group having 1 - 18 carbon atoms which may be each independently substituted; R⁴ is a hydrogen atom, a halogen atom, an aryl group or an alkyl group having 1 - 18 carbon atoms which may be each independently substituted; R⁵ is an aryl group, an alkylcarbonyl group, an alkyloxycarbonyl group or an alkyl group having 1 - 18 carbon atoms which may be substituted; and R⁶ is a hydrogen atom or a halogen atom. If the monomer unit has substituents at a plurality of locations, each may be different from each other. The substituents represented by R¹ to R⁵ may be further substituted with an alkyl group, an alkoxy group, a halogen atom, a hydroxyl group, an amino group, a thiol group, a silyl group, an ester group, an aryl group, a heteroaryl group. The alkoxy group or the alkyl group may be a straight chain, a branched chain, or an alicyclic chain.

The thiophene-2,5-diyl group which is the monomer unit of the polymer block (B) has at least at the 3-position an aryl group, an alkoxy group or an alkyl group having 1 - 18 carbon atoms as a substituent. The substituents may be substituted with an alkyl group, an alkoxy group, a halogen atom, a hydroxyl group, an amino group, a thiol group, a silyl group, an ester group, an aryl group, a heteroaryl group. The alkyl or alkoxy group as a substituent of the polymer block (B), may be a straight chain, a branched chain or an alicyclic chain

In a case where a monomer unit, in which two or more thiophene-2,5-diyl groups are bonded, is used as a monomer unit for the polymer block (B), it is sufficient that at least one of the thiophene-2,5-diyl groups has a substituent at the 3-position. A group in which 2 to 5 of thiophene-2,5-diyl groups are bonded is exemplified as a preferable example. As such a specific example, for example, bithiophene, terthiophene, etc., each of which includes at least one thiophene-2,5-diyl group having a substituent at the 3-position, can be exemplified. Further, the polymer block (B) may be a random copolymer having a plural types of thiophene-2,5-diyl group that has a substituent at least at the 3-position. From the viewpoint of the photoelectric conversion characteristics, it is preferable that the polymer block (B) is a random copolymer.

As the alkyl group having 1 - 18 carbon atoms, for example, methyl group, ethyl group, n-propyl group, isopropyl group, n-butyl group, isobutyl group, sec-butyl group, tert-butyl group, n-pentyl group, isopentyl group, neopentyl group, tert-pentyl group, n-hexyl group, isohexyl group, 2-ethylhexyl group, n-heptyl group, n-octyl, group, n-nonyl group, n-decyl group, cyclopropyl group, cyclopentyl group, cyclohexyl group, and cyclooctyl group, are exemplified.

As an example of the alkoxy group having 1 - 18 carbon atoms, for example, methoxy group, ethoxy group, n-propyloxy group, isopropoxy group, n-butoxy group, n-hexyloxy group, cyclohexyloxy group, n-octyloxy group, n-decyloxy group, n-dodecyloxy group and the like, are exemplified.

As an example of the alkoxy group optionally substituted with a substituent of the polymer block (A) and the polymer block (B), an alkoxy group such as methoxy group, ethoxy group, n-propyloxy group, isopropoxy group, n-butoxy group, n-hexyloxy group, cyclohexyloxy group, n-octyloxy group, n-decyloxy group and n-dodecyloxy group, are exemplified. As the halogen atom, for example, fluorine atom, chlorine atom, bromine atom, iodine atom, etc. are exemplified. As the alkyl group substituted with a halogen atom, for example, an ω-bromo alkyl group, a perfluoroalkyl group, etc. are exemplified.

As the amino group, for example, a primary or secondary amino group such as dimethylamino group, diphenylamino group, methylphenylamino group, methylamino group, ethyl amino group, etc. are exemplified. As the thiol group, for example, mercapto group, alkylthio group, etc. are exemplified. As the silyl group, for example, trimethylsilyl group, triethylsilyl group, tripropylsilyl group, triisopropylsilyl group, dimethylisopropylsilyl group, dimethyl-tert-butylsilyl group, etc. are exemplified.

As an example of the ester group, for example, methoxycarbonyl group, ethoxycarbonyl group, propoxycarbonyl group, isopropoxycarbonyl group, tert-butoxycarbonyl group, phenoxycarbonyl group, acetyloxy group, benzoyloxy group, etc. are exemplified.

As an example of the aryl group, for example, phenyl group, 1-naphthyl group, 2-naphthyl group, 1-anthracenyl group, 2-anthracenyl group, 9-anthracenyl group, etc. are exemplified, and those groups may further have a substituent such as alkyl group, alkoxy groups, etc. As examples of the heteroaryl group, for example, pyridyl group, thienyl group, furyl group and pyrrolyl group, etc. are exemplified.

Monomer units in the polymer block (A) or the polymer block (B) may have only the same structure including the structure of the substituent. However, if the effects of the present invention are not impaired, another monomer unit may be used together.

Bonding structure between the polymer block (A) and the polymer block (B) in the π-electron conjugated block copolymer of the present invention is not particularly limited, but as an example of the bonding type, for example, A-B type diblock copolymer, B-A type diblock copolymer, A-B-A type triblock copolymer, B-A-B type triblock copolymer, A-B-A-B type tetrablock copolymer, B-A-B-A type tetrablock copolymer, A-B-A-B-A type pentablock copolymer, B-A-B-A-B type pentablock copolymer, etc. are exemplified. The block copolymers of these types may be used alone or in combination of two or more bonding types.

Preferable weight ratio of the polymer block (A) to the polymer block (B) is 99 : 1 to 1 : 99, more preferably 95 : 5 to 5 : 95. When the weight ratio of the polymer block (A) or the polymer block (B) is too small, sufficient photoelectric conversion efficiency can not be achieved. More preferably, the weight ratio is in the range of 90 : 10 to 10 : 90, still more preferably, the ratio is in the range of 70 : 30 to 30 : 70.

The number average molecular weight of the present π-electron conjugated block copolymer is preferably in the range of 1,000 - 200,000 g/mol in view of workability, crystallinity, solubility, and photoelectric conversion characteristics, preferably from 5,000 - 100,000 g/mol, more preferably from 10,000 - 100,000 g/mol, still more preferably 20,000 - 100,000 g/mol. Solubility decreases and workability of the thin film decreases with increase in the number average molecular weight. When the number average molecular weight is set too low, properties such as crystalline properties, stability of the film, photoelectric conversion properties, are decreased. The number average molecular weight means the polystyrene conversion number average molecular weight in gel permeation chromatography (GPC). The number average molecular weight of the π-electron conjugated block copolymer of the present invention can be determined by conventional GPC using solvent such as tetrahydrofuran (THF), chloroform, dimethylformamide (DMF), etc. However, solubility of some π-electron conjugated block copolymer of the present invention is low at around room temperature. In such cases, the number average molecular weight may be determined using high temperature GPC with solvent such as dichlorobenzene, trichlorobenzene, etc.

The π-electron conjugated block copolymer may include any polymer block (C) that is different from the polymer block (A) and the polymer block (B). As such polymer block (C), for example, a single block comprising -a- unit, a single block comprising -b-unit, or a block comprising as a monomer unit a component containing a monocyclic or a fused (hetero) arylene group which is other than the -a- unit and the -b- unit, can be exemplified.

The structure of the π-electron conjugated block copolymer can be exemplified as follows when it includes a polymer block (C). As a structure in which the polymer block (A) is coupled or bonded contiguously with the polymer block (B), for example, A-B-C type triblock copolymer, B-A-C type triblock copolymer, C-A-B type triblock copolymer, C-B-A type triblock copolymer, A-B-A-C type tetrablock copolymer, B-A-B-C type tetrablock copolymer, C-A-B-A type tetrablock copolymer, C-B-A-B type tetrablock copolymer, C-A-B-C type tetrablock copolymer, C-B-A-C type tetrablock copolymer, C-A-B-A-C type pentablock copolymer, C-B-A-B-C type pentablock copolymer, A-B-A-B-C type pentablock copolymer, B-A-B-A-C type pentablock copolymer, C-B-A-B-A type pentablock copolymer, and C-A-B-A-B type pentablock copolymer and the like, can be exemplified

Further, the structure in which the polymer block (A) and the polymer block (B) are non-contiguously bonded is a term used to refer to a structure in which the polymer block (C) is inserted between the polymer block (A) and the polymer block (B). As examples of the polymer block in which the polymer block (A) and the polymer block (B) is non-contiguously bonded, for example, A-C-B type triblock copolymer, B-C-A type triblock copolymer, A-C-B-A type tetrablock copolymer, A-B-C-A type tetrablock copolymer, B-C-A-B type tetrablock copolymer, B-A-C-B type tetrablock copolymer, A-B-C-A-B type pentablock copolymer, A-C-B-C-A type pentablock copolymer, B-A-C-B-A type pentablock copolymer, B-C-A-C-B type pentablock copolymer and the like can be exemplified. In addition to the above mentioned triblock, tetrablock or pentablock copolymers, another polymer block (A), polymer block (B) or polymer block (C) may be bonded.

When the present π-electron conjugated block copolymer includes polymer block (C), the percentage of the polymer block (C) in the block copolymer is preferably 40% by mass or less. The polymer block (C) is a non-π-electron conjugated block copolymer, from the viewpoint that it does not contribute to photoelectric conversion, the percentage is preferably less than 30% by mass or less, still more preferably 20% by mass or less.

As a tool of analysis of the polymer structure of the π-electron conjugated block copolymer, such tools as solution NMR, an infrared spectroscopy and a Raman spectroscopy can be exemplified. The decomposition analysis by GCMS or secondary ion mass spectrometry can be used, too.

As examples of manufacturing methods of the present π-electron conjugated block copolymers, reaction steps and production methods will be described in detail below.

As the first method, the present π-electron conjugated block copolymer can be produced by separately synthesizing the polymer block (A) and the polymer block (B), then they are bonded to each other (hereinafter sometimes referred to as "bonding method"). As the second method, the polymer block (A) or the polymer block (B) is polymerized in the presence of the polymer block (A) or the polymer block (B) (hereinafter sometimes referred to as "macroinitiator method"). The bonding method or the macroinitiator method can be used as an optimal polymerization method depending on an intended type of the π-electron conjugated block copolymer.

Manufacturing of the π-electron conjugated block copolymer can be carried out by the bonding method, as shown in the following reaction formula (I). A compound A-M^{p} having a polymer block (A) which was prepared in advance and a compound B-X having polymer block (B) which was prepared in advance are subjected to a coupling reaction in the presence of a catalyst. Here, X and M^{p} is a terminal functional group of the polymer block.

A-M^{p} + B-X → A-B (I)

In the reaction formula (I), A and B represent polymer blocks, X is a halogen atom, M^{p} is boronic acid, boronic ester, -MgX, -ZnX, -SiX₃ or -SnRa₃ (here, Ra is a straight chain alkyl group having 1 - 4 carbon atoms).

Terminal substituents of the polymer block (A) and the polymer block (B) may be swapped with each other, and as shown in the following reaction formula (II), the π-electron conjugated block copolymer can also be produced by carrying out a coupling reaction between a compound B-M^{p} having the polymer block (B) and a compound A-X having the polymer block (A) in the presence of a catalyst.

B-M^{p} + A-X → A-B (II)

In the reaction formula (II), A, B, X and M^{p} are the same meanings as defined above.

Manufacturing method of the polymer block (A) will be explained below. According to the following reaction formula (III), monomers M^{q1}-Y-M^{q1} and M^{q2}-Z-M^{q2} are reacted in the presence of a catalyst to produce through a coupling reaction a compound A-X or a compound A-M^{p} including the polymer block (A). Here, Y and Z represented a heteroaryl skeleton that composes at least a portion of the monomer unit of the polymer block (A). M^{q1} and M^{q2} are functional groups which are involved in the coupling reaction.

M^{q1}-Y-M^{q1} + M^{q2}-Z-M^{q2} → A-X or A-M^{p} (III)

In the reaction formula (III), M^{q1} and M^{q2} are not the same and are each independently a halogen atom, boronic acid, boronic acid ester, -MgX, -ZnX, -SiX₃ or -SnRa₃ (Ra is a straight chain alkyl group having 1 - 4 carbon atoms). M^{p} represents boronic acid, boronic acid ester, -MgX, -ZnX, -SiX₃ or -SnRa₃. A and X are the same meanings as defined above. That is, if M^{q1} is a halogen atom, M^{q2} is boronic acid, boronic acid ester, -MgX, -ZnX, -SiX₃ or -SnRa₃. On the contrary, if M^{q2} is a halogen atom, M^{q1} is boronic acid, boronic acid ester, -MgX, -ZnX, -SiX₃ or -SnRa₃.

The polymer block (A) can be also produced through a coupling reaction from a compound M^{q1}-Y-M^{q1}, a compound M^{q2}-Z-M^{q2} and a compound represented by a formula Ar-M^{r} (hereinafter, it is referred to an endcapping agent in some cases). Here, Ar is an aryl group. M^{r} is M^{p} or X, and M^{p} and X are the same meanings as defined above.

In this way, like the compound A-X or A-M^{p}, a functional group for coupling to only one terminal group of the polymer block (A) can be easily introduced.

X or M^{p} of the compound A-X or A-M^{p} may be functional groups derived from M^{q1}-Y-M^{q1} or M^{q2}-Z-M^{q2}, which is the monomer of the polymer block (A) or may be functional groups derived from a linker compound M^{r}-Q-M^{r} that is different from the monomer of the polymer block (A). However, Q is an arylene group, M^{r} represents M^{p} or X, and M^{p} and X are the same meanings as defined above.

Q is preferably a divalent monocyclic arylene from the viewpoint of easy availability and reactivity, more preferably benzene or a divalent thiophene which may have a substituent. As specific examples, for example, 2,5-dibromothiophene, 2,5-bis(trimethyltin)thiophene, 2,5-thiophenediboronic acid, 2,5-bis(3,3,4,4-tetramethyl-2,5,1-dioxaborolane-1-yl)thiophene, p-dibromobenzene, p-bis(trimethyltin)benzene, p-benzenedibronic acid, p-bis(3,3,4,4-tetramethyl-2,5,1-dioxaborolane-1-yl)benzene, etc. are exemplified.

When the compound A-X or A-M^{p} is produced in accordance with the reaction formula (III), it is possible to introduce preferentially either M^{p} or X as the terminal functional group by excessively charging either monomer of M^{q1}-Y-M^{q1} or M^{q2}-Z-M^{q2}. However, since the polymerization does not proceed if either M^{q1}-Y-M^{q1} or M^{q2}-Z-M^{q2} is used too much, a molar ratio of M^{q1}-Y-M^{q1} to M^{q2}-Z-M^{q2} is preferable in the range of 0.5 - 1.5, and more preferably 0.7 - 1.3.

In addition to the above method, at an early, middle or late stage of polymerization between monomer M^{q1}-Y-M^{q1} and monomer M^{q2}-Z-M^{q2}, it is possible to add an excessive amount of the linker compound M^{r}-Q-M^{r} to preferentially introduce the linker compound at the terminal of the polymer block (A). The amount of the linker compound to be added is 1.5 times or more equivalent, preferably 2 times or more equivalent, more preferably 5 times or more equivalent of the terminal functional group calculated from a number average molecular weight (Mn) of the polymer block (A) during polymerization.

Next, a manufacturing method of the polymer block (B) will be explained. A polymer block (B), which comprises a monomer unit that is a thiophene-2,5-diyl group having a substituent at least at the 3-position thereof, can be synthesized in the following manner.

In an inert solvent, a monomer represented by the following formula (IV)

X-W-X (IV)

(in the formula (IV), W is a divalent thienylene group that has a substituent at least at the 3-position, X is a halogen atom, both of X may be identical or different from each other) and Grignard reagent (or an organomagnesium halide compound) represented by the following formula (V)

R'-MgX (V)

(in the formula (V), R' is an alkyl group having 1 - 10 carbon atoms, X is the same meaning as defined above) are exchange-reacted through the Grignard metathesis reaction to obtain an organomagnesium compound represented by the following formula (VI)

X-W-MgX (VI)

(in the formula (VI), W is a divalent thienylene group that may have a substituent, X is a halogen atom, both of X may be identical or different from each other).

A π-conjugated polymer is obtained in a solvent from the obtained organomagnesium compound (VI) in the presence of a metal complex catalyst through the so-called coupling reaction. A series of reactions are shown in the reaction formula (VII).

X-W-X → X-W-MgX → B-X (VII)

In the reaction formula (VII), W, B and X are the same meanings as defined above. Both of X are identical or different from each other.

It is also possible to obtain B-M^{p} (in this case, M^{p} is -MgX) by exerting again the action of the Grignard reagent to B-X that is obtained by the reaction formula (VII).

The compound represented by the formula (IV) is a polymer precursor needed to produce the polymer block (B), and is, more specifically, represented by the formula (1-1) below.

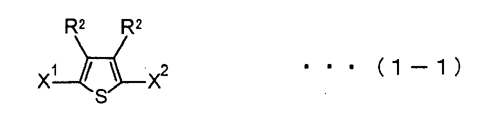

In the formula (1-1), R² is the same meaning as defined above. X¹ and X² are each iodine or bromine.

For example, a monomer unit of the formula (1-1) in which X¹ is iodine, X² is bromine, R² at the 3-position of thiophene ring is an n-hexyl group, and R² at the 4-position of thiophene ring is a hydrogen atom, can be synthesized through coupling of 3-bromothiophene with bromohexyl, then through bromination using N-bromosuccinimide, and then iodination using iodine. For more information, refer to A. Yokoyama, R. Miyakoshi, T. Yokozawa, Macromolecules, 40, p.4093 (2007).

It is also possible to produce compound B-X or B-M^{p}, a compound having a functional group at the end of the polymer block (B), through a method other than the method described above. Like in the polymer block (A), and in accordance with the reaction formula (III) and in the presence of a catalyst, a monomer M^{q1}-Y-M^{q1} and a monomer M^{q2}-Z-M^{q2} are reacted through a coupling reaction. Y and Z in this case represent a skeleton including at least one thiophene-2,5-diyl group having a substituent at the 3-position, which is a monomer unit of the polymer block (B). By using the coupling reaction, a random copolymer block having a plural types of thiophene-2,5-diyl group having a substituent at least at the 3-position thereof or another polymer block comprising a monomer unit in which a plurality of thiophene-2,5-diyl groups are bonded to constitute a monomer unit, are obtained as the polymer block (B). Of course, an endcapping agent can be used, if necessary.

Next, the macroinitiator method will be explained. The macroinitiator method is a method for carrying out the polymerization of the polymer block (B) in the presence of compound A-X or A-M^{p} that has the polymer block (A) at an early or a middle stage of polymerization of the polymer block (B). It is also possible to carry out polymerization of the polymer block (A) in the presence of the compound B-X or B-M^{p} that has the polymer block (B) at an early or a middle stage of polymerization of the polymer block (A). Optimal processing order can be determined for the intended purpose of the π-electron conjugated block copolymer. From the viewpoint of controlling the polymerization, it is more preferable that the polymerization of the polymer block (A) is carried out in the presence of the compound B-X or B-M^{p} that has the polymer block (B) and at an early or a middle stage of polymerization of the polymer block (A). From the viewpoint of reducing the synthesis step number, it is more preferable that polymerization of the polymer block (A) is carried out in the presence of the compound B-X that has the polymer block (B) and at an early or a middle stage of polymerization of the polymer block (A)

In more detail, as shown in the reaction formula according to (VIII) and in the presence of a catalyst, a compound B-X having the polymer block (B), M^{q1}-Y-M^{q1} and/or M^{q2}-Z-M^{q2} that are/is a monomer of the polymer block (A) are reacted to bond the terminal of the polymer block (B) and the monomer of the polymer block (A) or the polymer block (A) through a coupling reaction during polymerization, obtaining the present π-electron conjugated block copolymer comprising the polymer block (A) and the polymer block (B).

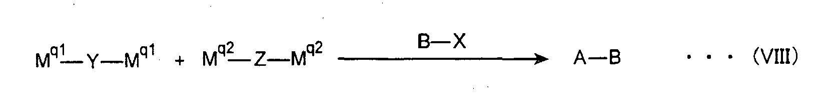

In reaction formula (VIII), Y, Z, M^{q1}, M^{q2}, A, B and X are the same meanings as defined above.

The polymer block (B) comprises a monomer unit of thiophene-2,5-diyl group having a substituent at least at the 3-position thereof. The substituent is an aryl group, an alkoxy group or an alkyl group having 1 - 18 carbon atoms which may be substituted with an alkoxy group, a halogen atom, a hydroxyl group, an amino group, a thiol group, a silyl group, an ester group, an aryl group or a heteroaryl group. The polymer block (B) can be synthesized by the methods described above using a monomer unit having a substituted an aryl group, an alkoxy group or an alkyl group with 1 - 18 carbon atoms. However, among the group of an alkoxy group, a halogen atom, a hydroxyl group, an amino group, a thiol group, a silyl group, an ester group, an aryl group and a heteroaryl group, especially a hydroxyl group, an amino group, a thiol group and a heteroaryl group may sometime inhibit the coupling reaction. However, even in such cases, it is possible to obtain a desired π-electron conjugated block copolymer by suitably protecting the hydroxyl group, the amino group, the thiol group and the heteroaryl group, or by modifying thereof after the completion of the coupling reaction. For example, a hydroxyl group can be protected by a benzyl group or a tetrahydropyranyl group, and an amino group can be protected by a benzyloxycarbonyl group or a t-butyloxycarbonyl group, etc. After the coupling reaction, such groups can be introduced into the polymer block (B) through a deprotection process. Concerning the thiol group, for example, a monomer having a halogen atom (more preferably a bromine atom)-substituted alkyl group or alkoxy group is subjected to the coupling reaction, and then the halogen atom is substituted with thioacetic acid and subsequently hydrolyzed to carry out the introduction. Of course, it is not limited to these methods, an appropriate method can be adopted depending on an intended purpose. In a case where the polymer block (A) has a substituent, synthesis can be carried out as well.

It is necessary to use a complex of a transition metal as a catalyst for both the bonding and the macroinitiator methods. Usually, a complex of a transition metal (group 3 - 10, especially group 8 - 10 of the periodic table, long form periodic table arranged according to 18 groups) are exemplified. Specifically, publicly known complexes of Ni, Pd, Ti, Zr, V, Cr, Co, Fe, etc. are exemplified. Among them, Ni complex and Pd complexes are more preferable. Further, as a ligand of the complex to be used, a monodentate phosphine ligand such as trimethylphosphine, triethylphosphine, triisopropylphosphine, tri-t-butylphosphine, tricyclohexylphosphine, triphenylphosphine, tris(2-methylphenyl)phosphine, etc.; a bidentate phosphine ligand such as diphenylphosphino methane (dppm), 1,2-diphenylphosphino ethane (dppe), 1,3-diphenylphosphino propane (dppp), 1,4-diphenylphosphino butane (pddb), 1,3-bis(dicyclohexylphosphino)propane (dcpp), 1,1'-bis(diphenylphosphino)ferrocene (dppf), 2,2-dimethyl-1,3-bis(diphenylphosphino)propane, etc.; a nitrogen-containing ligand such as tetramethylethylenediamine, bipyridine, acetonitrile, etc. are preferably contained.

In the bonding method and the macroinitiator method, the amount of the complex to be used is depending on the type of the π-electron conjugated block copolymer, 0.001 - 0.1 mol for the monomer is preferably used. When the amount of catalyst is excessively used, molecular weight of the polymer becomes low and it is economically disadvantageous. On the other hand, the amount of catalyst is added too small, reaction rate becomes deteriorated, causing difficulty in stable production.

The present π-electron conjugated block copolymer is preferably prepared in the presence of solvent. The type of the solvent should be selectively used depending on the type of the π-electron conjugated block copolymer. However, generally available solvent can be selected and used for the processes of the bonding method and the macroinitiator method. For example, ether solvents such as tetrahydrofuran, 2-methyltetrahydrofuran, 1,4-dioxane, dimethyl ether, ethyl methyl ether, diethyl ether, dipropyl ether, butyl methyl ether, t-butyl methyl ether, dibutyl ether, cyclopentyl methyl ether, and diphenyl ether, etc.; aliphatic or alicyclic saturated hydrocarbon solvents such as pentane, hexane, heptane and cyclohexane, etc.; aromatic hydrocarbon solvents such as benzene, toluene, and xylene, etc.; alkyl halide solvents such as dichloromethane, chloroform, etc.; aromatic aryl halide solvents such as chlorobenzene, dichlorobenzene, etc.; amide solvents such as dimethylformamide, diethyl formamide, N-methylpyrrolidone, etc.; and water and a mixtures thereof, can be exemplified. The amount of the organic solvent to be used is preferably in the range of 1 - 1,000 times by weight for a monomer of the π-electron conjugated block copolymer, and preferably is 10 times by weight or more from the point of view of stirring efficiency of the reaction mixture and solubility of the bonding body. It is preferably in the range of 100 times or less by weight from the viewpoint of a reaction rate.

The polymerization temperature varies depending on the type of the π-electron conjugated block copolymer. The bonding method and the macroinitiator method are generally carried out at temperature in the range of -80°C - 200°C. There is no specific limit for reaction pressure, but the pressure is preferably in the range of 0.1 - 10 atms. Generally, reaction is carried out at about 1 atm. The reaction time varies depending on the type of the π-electron conjugated block copolymer, but the reaction time is usually 20 minutes - 100 hours.

The π-electron conjugated block copolymer that is synthesized by the bonding method or the macroinitiator method can be obtained by, for example, conventional steps such as re-precipitation, removal of the solvent under heating, at a reduced pressure or by steaming (steam stripping). These steps are usually processed to separate the π-electron conjugated block copolymer from reaction mixtures and by-products. The obtained crude products can be purified by extracting or washing with generally available solvent using a Soxhlet extractor. For example, ether solvents such as tetrahydrofuran, 2-methyltetrahydrofuran, 1,4-dioxane, dimethyl ether, ethyl methyl ether, diethyl ether, dipropyl ether, butyl methyl ether, t-butyl methyl ether, dibutyl ether, cyclopentyl methyl ether, diphenyl ether and the like; aliphatic or alicyclic saturated hydrocarbon solvents such as pentane, hexane, heptane cyclohexane and the like; aromatic hydrocarbon solvents such as benzene, toluene, xylene, and the like; ketone solvents such as acetone, ethyl methyl ketone, diethyl ketone and the like; halogenated alkyl solvents such as dichloromethane, chloroform and the like; aromatic aryl halide solvents such as chlorobenzene and dichlorobenzene and the like; amide solvents such as dimethylformamide, diethyl formamide, N-methylpyrrolidone and the like; and water and mixtures thereof are exemplified.

The present π-electron conjugated block copolymer mentioned above may have, as a terminal group, a coupling residue such as a halogen atom, a trialkyl tin group, a boronic acid group, a boronic acid ester group, or a desorbed hydrogen atom that are caught by the atoms or groups mentioned above. Further, these terminal groups may be a terminal structure that is substituted with an endcapping agent comprising aromatic boronic acid compounds or aromatic halides such as benzene bromides etc.

As long as the effect of the present invention is not impaired, a homopolymer and a random polymer of components such as the polymer block (A) and the polymer block (B) may be remained on the π-electron conjugated block copolymer. The amount of such residual components is preferably 70% or less.

The present π-electron conjugated block copolymer can be used in the photoelectric conversion active layer of the photoelectric conversion element by providing a composition containing an electron accepting material. If the organic material in the composition has n-type semiconductor characteristics, any electron accepting material can be used. For example, oxazole derivatives such as 1,4,5,8-naphthalenetetracarboxylic dianhydride (NTCDA), 3,4,9,10-perylene-tetracarboxylic-dianhydride (PTCDA), N,N'-dioctyl-3,4,9,10-naphthyl tetracarboxylic diimide (NTCDIC8H), 2-(4-biphenylyl)-5-(4-t-butylphenyl)-1,3,4-oxadiazole, 2,5-di(1-naphthyl)-1,3,4-oxadiazole, etc.; triazole derivatives such as 3-(4-biphenylyl)-4-phenyl-5-(4-t-butylphenyl)-1,2,4-triazole, etc.; phenanthroline derivatives; fullerene derivatives such as C₆₀ or C₇₀; carbon nanotubes (CNT); derivatives (CN-PPV) obtained by introducing a cyano group into a poly-p-phenylenevinylene polymers, etc. are exemplified. These may be used alone respectively or used by mixing two or more thereof. Among them, the fullerene derivatives are preferably used, from the viewpoint that these n-type semiconductors have an excellent carrier mobility and stability.

As fullerene derivatives preferably used in the present invention as an electron accepting material, for example, non-substituted ones such as C₆₀, C₇₀, C₇₆, C₇₈, C₈₂, C₈₄, C₉₀ and C₉₄ are exemplified; and for example, substituted ones such as [6,6]-phenyl C₆₁ butyric acid methyl ester ([6,6]-C₆₁-PCBM), [5,6]-phenyl C₆₁ butyric acid methyl ester, [6,6]-phenyl C₆₁ butyric acid n-butyl ester, [6,6]-phenyl C₆₁ butyric acid i-butyl ester, [6,6]-phenyl C₆₁ butyric acid hexyl ester, [6,6]-phenyl C₆₁ butyric acid dodecyl ester, [6,6]-diphenyl C₆₂ bis(butyric acid methyl ester) ([6,6]-C₆₂-bis-PCBM), [6,6]-phenyl C₇₁ butyric acid methyl ester ([6,6]-C₇₁-PCBM), etc. are also exemplified.

The fullerene derivatives mentioned above can be used alone or as a mixture thereof. but from the viewpoint of solubility in organic solvents, [6,6]-C₆₁-PCBM, [6,6]-C₆₂-bis-PCBM, [6,6]-C₇₁-PCBM are preferably used.

A photoelectric conversion element of the present invention comprises an organic photoelectric conversion layer which is provided from the composition comprising the π-electron conjugated block copolymer and electron accepting materials, and is capable of generating electricity due to function of the layer provided from the composition.

As long as the objects of the present invention are not impaired, the composition of the present invention may include other components such as surfactants, binder resins, fillers, etc.

The ratio of the electron accepting material in the composition is in the range of 10 - 1,000 parts by weight against 100 parts by weight of the π-electron conjugated block copolymer, more preferably 50 - 500 parts by weight.

A mixing method of the π-electron conjugated block copolymer and the electron accepting material is not particularly limited, but after the addition of a solvent in a desired ratio, the mixture is subjected to one or more processes including processes of heating, stirring, ultrasonic irradiation, etc. to dissolve them into the solvent, is exemplified.

The solvent to be used is not specifically limited, but the solvent should be selected from the viewpoint of solubility of each of the π-electron conjugated block copolymer and the electron accepting material at 20°C. Preferable solubility at 20°C is 1 mg/mL or more from the viewpoint of forming the organic thin film. In the case of a solubility of less than 1 mg/mL, it is difficult to produce homogeneous organic thin film, accordingly it is impossible to obtain a composition of the present invention. Furthermore, from the viewpoint of arbitrarily controlling the film thickness of the organic thin film, a solvent having the solubility of 3 mg/mL or more at 20°C for each of the π-electron conjugated block copolymer and the electron accepting material, is preferably used. Further, the boiling points of these solvents are preferably from the viewpoint of the manufacturing process in the range of room temperature to 200°C.

As the solvents, for example, tetrahydrofuran, 1,2-dichloroethane, cyclohexane, chloroform, bromoform, benzene, toluene, o-xylene, chlorobenzene, bromobenzene, iodobenzene, o-dichlorobenzene, anisole, methoxybenzene, trichlorobenzene, pyridine, and the like are exemplified. Well, these solvents may be used alone or may be used by mixing two or more. Especially in view of the high solubility of the π-electron conjugated block copolymer and the electron accepting material, o-dichlorobenzene, chlorobenzene, bromobenzene, iodobenzene, chloroform, and the mixtures of them are preferable used. More preferably, o-dichlorobenzene, chlorobenzene, or the mixtures thereof are used.

In addition to the π-electron conjugated block copolymer and the electron accepting material, additives having a boiling point higher than that of the solvent may be added into the solution described above. By the presence of the additives, fine and continuous phase-separated structure of the π-electron conjugated block copolymer and the electron accepting material can be formed during an organic thin film-forming process. Accordingly, it is possible to obtain an active layer excellent in photoelectric conversion efficiency. As the additives, octanedithiol (boiling point: 270°C), dibromooctane (boiling point: 272°C), diiodooctane (boiling point: 327°C) and the like are exemplified.

The amount of the additives to be added is not particularly limited as long as the π-electron conjugated block copolymer and the electron accepting material are not deposited and a homogeneous solution is given, but the addition amount is preferably in the range of 0.1 - 20% by volume of the solvent. When additives are added in less than 0.1%, it is impossible to obtain a sufficient effect in continuous fine phase separation structure, on the contrary when more than 20%, drying rate becomes slow, so that it is difficult to obtain a homogeneous organic thin film. More preferably, the amount of additives is in the range of 0.5% - 10%.

The thickness of the organic photoelectric conversion layer is usually in the range of 1 nm - 1 µm, preferably in the range of 2 nm - 1,000 nm, more preferably 5 nm - 500 µm, still more preferably 20 nm - 300 µm. Light is not sufficiently absorbed if the film thickness is too thin. The carrier does not easily reach to an electrode if the film is too thick on the contrary.

A coating method of the solution containing the π-electron conjugated block copolymer and the electron accepting material, on a substrate or a support is not particularly limited. Any conventionally known coating methods using liquid type coating materials can be employed. For example, any coating method such as a dip coating method, a spray coating method, an ink jet method, an aerosol jet method, a spin coating method, a bead coating method, a wire bar coating method, a blade coating method, a roller coating method, a curtain coating method, a slit die coater method, a gravure coater method, a slit reverse coater method, a micro gravure method, and a comma coater method, etc. can be employed depending on the coating characteristics such as alignment control, coating thickness, etc.

The organic photoelectric conversion layer may be additionally subjected to thermal annealing, if necessary. The thermal annealing of an organic thin film on the substrate is performed by holding the desired temperature. The thermal annealing may be performed under an inert gas atmosphere or under reduced pressure. Preferred temperature is 40°C - 300°C, more preferably, 70°C - 200°C. Sufficient effect is not obtained when the temperature is low. When temperature is too high, oxidation and/or degradation occurs in the organic thin film, sufficient photoelectric conversion characteristics are not obtained.

The substrates on which the photoelectric conversion element of the present invention is formed, may be any film or plate which does not change when forming the organic photoelectric conversion layer and electrodes. For example, inorganic material such as non-alkali glass or quartz glass, metal film such as aluminum, organic material such as polyester, polycarbonate, polyolefin, polyamide, polyimide, polyphenylene sulfide, polyparaxylene, epoxy resin, fluorine resin, etc. can be used. In the case of using an opaque substrate, the opposite electrode (i.e., the electrode that is located far from the substrate) that is transparent or semi-transparent is preferably used. The thickness of the substrate is not particularly limited, but is usually in the range of 1 µm - 10 mm.

Light permeability is necessary for either one of positive or negative electrode of the photovoltaic element. As long as incident light reaches the organic photoelectric conversion layer and generates the electromotive forces, the light transmittance of the electrode is not particularly limited. The thickness of the electrode is depending on electrode materials, but is not particularly limited. However preferably in the range of 20 nm - 300 nm as long as the electrode is electrically conductive and optically transparent. The optical transparency is not specifically required for the other electrode as long as the other electrode is electrically conductive. The thickness thereof is not particularly limited.

As the positive electrode, metal such as lithium, magnesium, calcium, tin, gold, platinum, silver, copper, chromium, nickel etc.; and as an transparent electrode, metal oxide such as indium, tin, etc. and complex metal oxide such as indium tin oxide (ITO), indium zinc oxide (IZO), fluorine-doped tin oxide (FTO), etc.; are preferably used. As manufacturing methods of a grid electrode which is transparent because of using a mesh metal, or polyaniline and its derivatives, for example, a vacuum deposition method, a sputtering method, an ion plating method, a plating method and the like can be exemplified. The positive electrode can also be manufactured by a coating method using metal ink, metal paste, low melting point metal, organic conductive ink, etc.

An increase in an output current can be realized by introducing, between the organic photoelectric conversion layer and the negative electrode, metal fluoride such as lithium fluoride, sodium fluoride, potassium fluoride, magnesium fluoride, calcium fluoride, or cesium fluoride. More preferably, lithium fluoride or cesium fluoride is introduced.

A hole transporting layer may be provided between the organic photoelectric conversion layer and the positive electrode if necessary. As a material for forming the hole transporting layer is not particularly limited as long as it has a p-type semiconductor properties. Conductive polymers such as polythiophene containing polymer, polyaniline containing polymer, poly-p-phenylenevinylene containing polymer, polyfluorene containing polymer, etc.; low molecular weight organic compounds having p-type semiconductor characteristics such as phthalocyanine (Pc), phthalocyanine derivatives (such as copper phthalocyanine, zinc phthalocyanine, etc.), porphyrin derivatives, etc.; metal oxides such as molybdenum oxide, zinc oxide, vanadium oxide, etc. are preferably used. The thickness of the hole transporting layer is preferably in the range of 1 nm - 600 nm, more preferably 20 nm - 300 nm.

An electron transporting layer may be provided between the active layer and the negative electrode if necessary. A material for forming the electron transporting layer is not particularly limited as long as it has n-type semiconductor characteristics. The electron accepting organic material described above, for example, NTCDA, PTCDA, NTCDI-C8H, oxazole derivatives, triazole derivatives, phenanthroline derivatives, fullerene derivatives, CNT, CN-PPV, etc. are preferably used. The thickness of the electron transporting layer is preferably in the range of 1 nm - 600 nm, more preferably 5 nm - 100nm.

When providing a hole transporting layer between the active layer and the positive electrode using the conductive polymer that is soluble in a solvent, a coating or applying method such as a dip coating method, a spray coating method, an inkjet method, an aerosol jet method, a spin coating method, a bead coating method, a wire bar coating method, a blade coating method, a roller coating method, a curtain coating method, a slit die coater method, a gravure coater method, a slit reverse coater method, micro gravure method, comma coater method, etc., can be used. When using a low molecular weight organic material such as porphyrin derivatives or phthalocyanine derivatives, a deposition method using a vacuum deposition device can be preferably used. The electron transporting layer can also be produced in the same manner as described above.

The photoelectric conversion element of the present invention is applicable to various photoelectric conversion devices having photoelectric conversion function and optical rectification function, etc. For example, the photoelectric conversion elements can be used for photovoltaic cells (such as solar cells, etc.), electric devices (such as light sensors, light switches, photo transistors, etc.), and optical recording materials (such as optical memories, etc.).

### EMBODIMENTS

Examples of the present invention are described in detail, but the scope of the present invention is not limited by these examples.

Measurement of physical properties and purification methods of the materials produced in the respective steps described above and in the following steps, were carried out as follows.

### [Weight Average Molecular Weight (Mw), Number Average Molecular Weight (Mn)]

Number average molecular weight and weight average molecular weight are determined based on the measurement of gel permeation chromatography (GPC), obtained in terms of polystyrene-converted value using a GPC apparatus (HLC-8020, trade name, produced by Tosoh Corporation) with two columns connected in series (Trade name, TSKgel Multipore HZ, produced by Tosoh Corporation). Measurements were carried out using chloroform as solvent, at 40°C.

### [Purification of Polymers]

Purification of the obtained polymers was carried out using a preparative GPC column. A chromatograph apparatus (Recycling Preparative HPLC LC-908 produced by Japan Analytical Industry Co., Ltd.) is used therefor. Two columns (2H-40 and 2.5H-40, produced by Japan Analytical Industry Co., Ltd.) were connected in series (elution solvent: chloroform).

### [Purification of Solvent (THF)]

Dehydrated tetrahydrofuran (stabilizer free THF, produced by Wako Pure Chemical Industries, Ltd.) was distilled and purified in the presence of metallic sodium. After distillation, the solvent was contacted with molecular sieves 5A (produced by Wako Pure Chemical Industries, Ltd.) for more than one day.

### [¹H-NMR Measurement]

¹H-NMR measurement was carried out using NMR spectrometer (JEOL JNM-EX270 FT produced by JEOL Ltd.). Unless otherwise indicated, ¹H-NMR measurement was carried out at room temperature and at 270 MHz with chloroform (CDCl₃).

### [Synthesis Example 1]

A monomer represented by the following formula (i) was synthesized.

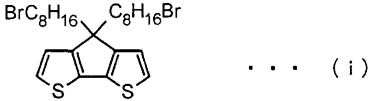

Under a nitrogen atmosphere, cyclopenta[2,1-b:3,4-b']dithiophene (0.36 g, 2.0 mmol) and tetrahydrofuran (30 mL) were charged into a 100 mL three-necked flask and cooled to below 0°C. Then 1.6M solution of n-butyl lithium in hexane (1.38 mL, 2.2 mmol) was slowly added dropwise, followed by stirring for 1 hour after the temperature was raised to room temperature. After the temperature was cooled down again to 0°C, 8-bromo-1-iodo-octane (0.64 g, 2.0 mmol) was added, followed by stirring for 1 hour. Then 1.6M solution of n-butyl lithium in hexane (1.38 ml, 2.2 mmol) was slowly added dropwise. After the temperature was raised to room temperature, stirring was continued for 1 hour. The temperature was cooled down below 0°C. Then 8-bromo-1-iodo-octane (0.64 g, 2.0 mmol) was added, followed by stirring for 1 hour. After completion of the reaction, the reacted mixture was poured into saturated brine (100 mL) and extracted with ethyl acetate (30 mL × 3), washed with water (30 mL × 3). The resulting organic layer was dried over sodium sulfate and then solvent was evaporated under reduced pressure. The obtained crude product was purified using silica gel column chromatography (hexane), obtaining a pale yellow solid of 4,4-bis(8-bromooctyl)cyclopenta[2,1-b:3,4-b']dithiophene (0.88 g, 78%) which is represented by the formula (i).
¹H-NMR (270 MHz): δ = 7.12 (d, J = 4.9 Hz, 2H), 7.07 (d, J = 4.9 Hz, 2H), 3.15 (t, J = 7.0 Hz, 4H), 2.33 - 2.10 (m, 4H), 1.52 - 1.41 (m, 12H), 1.38 - 1.09 (m, 16H)
MS (GC-MS) m / z = 560 (M⁺)

### [Synthesis Example 2]

A monomer represented by the following formula (ii) was synthesized.

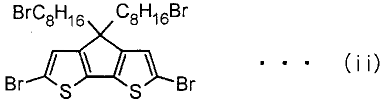

Under a nitrogen atmosphere, the compound (0.62 g, 1.1 mmol) represented by formula (i) and tetrahydrofuran (13 mL) were charged into a 100 mL three-necked flask, and then cooled to below 0°C. Then, N-bromosuccinimide (0.39 g, 2.2 mmol) was added slowly, followed by stirring for 1 hour at below 0°C. The temperature was raised to room temperature. After the completion of the reaction, the reacted mixture was poured into saturated brine (100 mL), then extracted with hexane (30 mL × 3), then washed with water (30 mL × 3). The obtained organic layer was dried over sodium sulfate, then the solvent was evaporated under reduced pressure, obtaining a crude product that was purified using silica gel column chromatography (hexane) to obtain an yellow solid of 2,6-dibromo-4,4-bis(8-bromooctyl)cyclopenta[2,1-b:3,4-b']dithiophene (0.7 g, 88%) that is represented by the formula (ii).
¹H-NMR (270 MHz): δ = 6.94 (s, 2H), 3.15 (t, J = 7.0 Hz, 4H), 2.35 - 2.12 (m, 4H), 1.54 - 1.40 (m, 12H), 1.37 - 1.06 (m, 16H)
MS (GC-MS) m / z = 718

Synthesis methods of monomers from which other polymer blocks described below are synthesized, are described, for example, in the documents listed below.
J. Am. Chem. Soc., 130, p.7812 (2008), Adv. Funct. Mater., 19, p.3262 (2009), Adv. Mater., 15, p.988 (2003), J. Poly. chem. Part A., 49, p.4368 (2011), US2008/006324A1, Organometallics, 30, p.3233 (2011), WO2011/011545A1, J. Am. Chem. Soc., 131, p.7792 (2009), J. Phys. Chem. B, 114, p.3095 (2010), J. Am. Chem. Sci., 133. p.4250 (2011), J. Am. Chem. Sci., 133. p.9638 (2011), and Macromolecules, 42, p.9217 (2009).

### [Polymerization Example 1]

A polymer block (A1) was synthesized according to the reaction formula below.

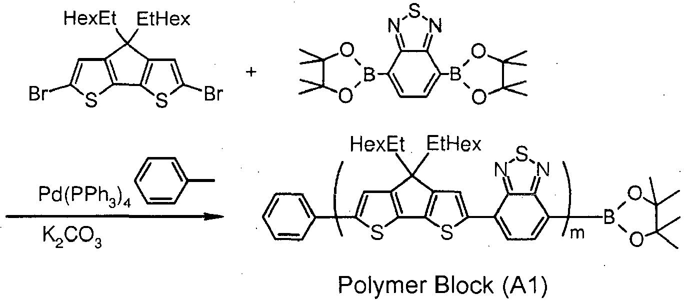

Under a nitrogen atmosphere, in a 100 mL three-necked flask, 4,7-bis(3,3,4,4-tetramethyl-2,5,1-dioxaborolane-1-yl)benzo[c][1,2,5]thiadiazole (1.04 g, 2.68 mmol) and 2,6-dibromo-4,4'-bis(2-ethylhexyl)cyclopenta[2,1-b:3,4-b']dithiophene(1.50 g, 2.68 mmol), which were monomers that would constitute the polymer block (A1), were added, and, further, toluene (50 mL), 2M aqueous solution of potassium carbonate (25 mL, 50 mmol), tetrakis(triphenylphosphine)palladium(0) (61.9 mg, 53.5 µmol) and aliquat 336 (2 mg, 4.95 µmol) were added. The mixture was stirred for 2 hours at 80°C. After that, phenylboronic acid pinacol ester (0.27 g, 1.34 mmol) was added as an endcapping agent, and stirred for 18 hours at 80°C. After completion of the reaction, the reacted solution was poured in methanol (500 mL), the precipitated solid was collected by filtration, washed with water (100 mL) and methanol (100 mL). The obtained solid was dried under reduced pressure, obtaining a crude product. After the crude product was washed with acetone (200 mL), hexane (200 mL) and then extracted with chloroform (200 mL) using a Soxhlet extractor. The resulting solution was concentrated, then poured into methanol (2 L) to precipitate a solid that was collected by filtration and then dried under reduced pressure, obtaining the polymer block (A1) (1.04 g, 73%), as a black purple solid. The weight average molecular weight (Mw) and the number average molecular weight (Mn) of the obtained polymer block (A1) were each 45,500 and 19,600. The polydispersity thereof was 2.32.
¹H-NMR (270 MHz): δ = 8.10 - 7.95 (m, 2H), 7.80 - 7 .61 (m, 2H), 2.35 - 2.12 (m, 4H), 1. 60 - 1.32 (m, 18H), 1.18-0.82 (m, 12H)

### [Polymerization Example 2]

A polymer block (A2) was synthesized according to the reaction formula below.

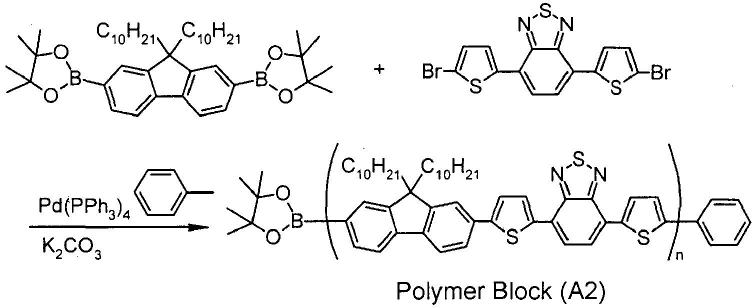

Under a nitrogen atmosphere, into a 100 mL three-necked flask, 4,7-di(2'-buromothie-5'-yl)-2,1,3-benzothiadiazole (1.23 g, 2.68 mmol) and 2,7-bis(3,3,4,4-tetramethyl-2,5,1-dioxaborolane-1-yl)-9,9-didecyl fluorene (1.62 g, 2.68 mmol), which were monomers that would constitute the polymer block (A2), were added. And further tetrakis(triphenylphosphine)palladium(0) (61.9 mg, 53.5 µmol) and toluene (50 mL) were added, and then the mixture was stirred for 10 minutes under reflux. Stirring was continued for 3 hours at 80°C after 20% tetraethylammonium hydroxide (8 mL) was added. Then, phenylboronic acid pinacol ester (0.27 g, 1.34 mmol) was added as an endcapping agent and stirred for 18 hours at 80°C. After completion of the reaction, the reacted solution was poured into methanol (500 mL). The precipitated solid was collected by filtration, washed with water (100 mL) and methanol (100 mL). The obtained solid was dried under reduced pressure to obtain a crude product. The crude product was washed with acetone (200 mL) and hexane (200 mL), then extracted with chloroform (200 mL) using a Soxhlet extractor. The obtained solution was concentrated and poured into methanol (2 L) to obtain a precipitated solid which was then collected by filtration, and dried under reduced pressure, obtaining the polymer block (A2) (1.28 g, 64%) as a black purple solid. The weight average molecular weight (Mw) and the number average molecular weight (Mn) of the obtained polymer block (A2) were each 47,400 and 18,900. The polydispersity thereof was 2.51.
¹H-NMR (270 MHz): δ = 8.11 (d, J = 3.5 Hz, 2H), 7.45 (d, J = 3.6 Hz, 2H), 2.32 - 2.11 (m, 4H), 1.61 - 1.34 (m, 28H), 1.32 - 1.20 (m, 4H) 1.15 - 0.82 (m, 6H)

### [Polymerization Example 3]

A polymer block (A3) was synthesized according to the reaction formula below.

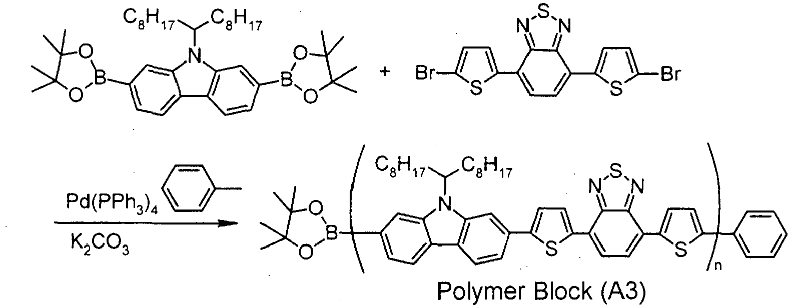

The polymer block (A3) (1.15 g, 61%) was obtained in the same manner as described in Polymerization Example 2, except that 4,7-di(2'-buromothie-5'-yl)-2,1,3-benzothiadiazole (1.23 g, 2.68 mmol) and 2,7-bis(3,3,4,4-tetramethyl-2,5,1-dioxaborolane-1-yl)-N-(heptadecane-9-yl)carbazole (1.51 g, 2.68 mmol), which were monomers that would constitute the polymer block (A3), were used. The weight average molecular weight (Mw) and the number average molecular weight (Mn) of the polymer block (A3) were each 36,000 and 17,400. And the polydispersity thereof was 2.07.
¹H-NMR (270 MHz): δ = 8.11 (d, J = 3.5 Hz, 2H), 8.02 (d, J = 7.0 Hz, 2H), 7.94 (br, 2H), 7.75 (br, 2H), 7.56 (d, J = 3.8 Hz, 2H), 7.45 (d, J = 3.5 Hz, 2H), 4.73 (br, 1H), 2.42 (br, 2H), 2.05 (br, 2H), 1.25 - 1.18 (m, 8H), 0.75 - 0.65 (m, 3H)

### [Polymerization Example 4]

A polymer block (A4) was synthesized according to the reaction formula below.

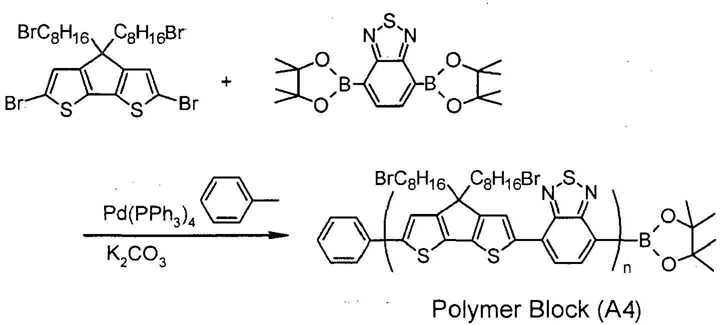

The polymer block (A4) (1.24 g, 67%) was obtained in the same manner as described in Polymerization Example 1 except that 4,7-bis(3,3,4,4-tetramethyl-2,5,1-dioxaborolane-1-yl)benzo[c][1,2,5]thiadiazole (1.04 g, 2.68 mmol) and 2,6-dibromo-4,4'-bis(8-bromooctyl)cyclopenta[2,1-b:3,4-b']dithiophene (1.92 g, 2.68 mmol), which were monomers that would constitute the polymer block (A4) were used. The weight average molecular weight (Mw) and the number average molecular weight (Mn) of the obtained polymer block (A4) were each 40,800 and 17,500. The polydispersity thereof was 2.33.
¹H-NMR (270 MHz): δ = 8.10 - 7.95 (m, 2H), 7.82 - 7.60 (m, 2H), 3.18 - 2.97 (m, 4H), 2.32 - 2.07 (m, 4H), 1.62 - 1.34 (m, 8H), 1.36 - 1.09 (m, 16H)

### [Polymerization Example 5]

A polymer block (B1) was synthesized according to the reaction formula below.

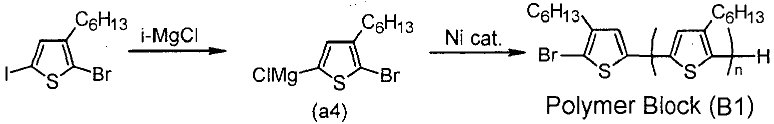

Into an eggplant flask (A) that was sufficiently dried and purged with argon, THF (25 mL) which was subjected to dehydration and peroxide removal processes, 2-bromo-5-iodo-3-hexylthiophene (1.865 g, 5 mmol) and 2.0M solution (2.5 mL) of i-propylmagnesium chloride were added and stirred for 30 minutes at 0°C to synthesize a solution of organomagnesium compound represented by formula (a4) in the reaction formula described above.

Into an eggplant flask (B) that was dried and purged with argon, THF (25 mL) which was subjected to dehydration and peroxide removal processes and NiCl₂(dppp) (27 mg, 0.05 mmol) were added and heated at 35°C, then the solution of the organomagnesium compound (a4) was added. After 1.5 hours stirring at 35°C, 5M hydrochloric acid (50 mL) was added and stirred for 1 hour at room temperature. The reacted solution was extracted with chloroform (450 mL). The resulting organic layer was washed with aqueous sodium bicarbonate (100 mL) and distilled water (100 mL) sequentially, and dried over anhydrous sodium sulfate, after concentrated to dryness. The obtained black purple solid was dissolved in chloroform (30 mL), was reprecipitated in methanol (300 mL), was dried sufficiently, and then purified using a preparative GPC column, obtaining the polymer block (B1) (0.69 g, 83%). The weight average molecular weight and the number average molecular weight of the obtained polymer block (B1) were each 24,200 and 21,000. The polydispersity thereof was 1.15.
¹H-NMR (270 MHz): δ = 6.97 (s, 1H), 2.80 (t, J = 8.0 Hz, 2H), 1.89 - 1.27 (m, 10H), 0.91 (t, J = 6.8 Hz, 3H)

### [Polymerization Example 6]

A polymer block (B2) was synthesized according to the reaction formula below.

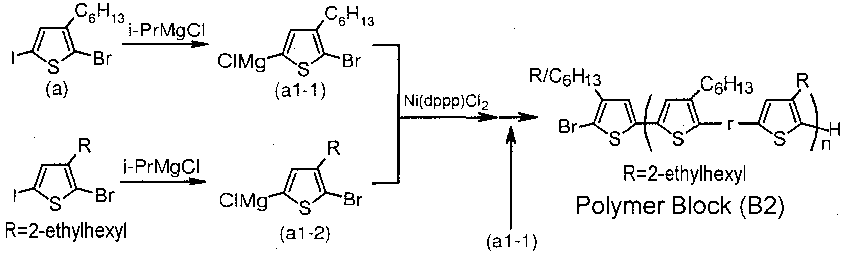

In an eggplant flask (A) that was dried and purged with argon, THF (25 mL) which was subjected to dehydration and peroxide removal processes and NiCl₂(dppp) (30 mg, 0.06 mmol, a polymerization catalyst) were added. In another dried eggplant flask (B), THF (15 mL) which was subjected to dehydration and peroxide removal processes, bromo-5-iodo-3-hexylthiophene (0.22 g, 0.58 mmol), 2-bromo-5-iodo-3-(2-ethylhexyl)thiophene (0.92 g, 2.29 mmol) and 2.0M solution (1.4 mL) of i-propylmagnesium bromide were added and stirred for 30 minutes at 0°C, synthesizing organomagnesium compounds (a1-1, a1-2). After that, the reacted mixture was added to the eggplant flask (A), polymerization was carried out over a period of 30 minutes at 35°C. After completion of the polymerization, a reacted solution including an organomagnesium compound (a1-1) which was synthesized in still another dried eggplant glass flask (C) in which THF (15 mL) that was subjected to dehydration and peroxide removal processes, 2-bromo-5-iodo-3-hexylthiophene (1.12 g, 3.0 mmol) and 2.0M solution (1.5 mL) of i-propylmagnesium chloride were added and allowed to react for 30 minutes at 0°C, was added dropwise for over 3 hours and was allowed to react for another 4 hours. After the reaction, 1.0M solution (2.0 mL) of t-butyl magnesium chloride in THF was added and stirred for 1 hour. Further, 5M hydrochloric acid (50 mL) was added to stop the polymerization by stirring of 1 hour. Thereafter, the polymer block (B2) (0.58 g, 56%) was obtained in the same manner as described in the Polymerization Example 5. The weight average molecular weight and the number average molecular weight of the polymer block (B2) were each 27,800 and 12,800. The polydispersity thereof was 2.16.
¹H-NMR (270 MHz): δ = 6.97 (s, 1H), 6.94 (s, 0.4H), 2.80 (t, J = 8.0 Hz, 2.8H), 1.70 - 1.25 (m, 11.6H), 0.94 - 0.89 (m, 5.4H)

### [Polymerization Example 7]

A polymer block (B3) was synthesized according to the reaction formula below.

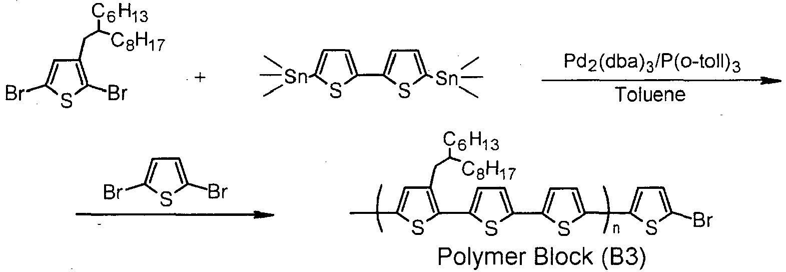

Under a nitrogen atmosphere, in a 50 mL eggplant flask, tris(o-tolyl)phosphine (37 mg, 0.12 mmol), tris(dibenzylideneacetone)dipalladium (14 mg, 15 µmol) and chlorobenzene (32 mL) were added and heated for 10 minutes at 50°C. After heating, the temperature was once allowed to cool down to room temperature, and 5,5'-bis(trimethylstannyl)-2,2'-bithiophene (0.37 g, 0.75 mmol) and 2,5-dibromo-3-(2-hexyldecyl)thiophene (0.35 g, 0.75 mmol), which were monomers that would constitute the polymer block (B3); were added and was allowed to react for 24 hours at 130°C. Then, 2,5-dibromothiophene (1.83 g, 7.50 mmol) was added as a linker compound and stirred for 16 hours at 130°C. After completion of the reaction, the reacted solution was poured into a mixture of methanol (200 mL) and hydrochloric acid (5 mL), then filtered to collect a precipitated solid and washed with water (20 mL) and methanol (20 mL). The obtained solid was dried under reduced pressure, obtaining a crude product. The crude product was washed with acetone (100 mL) and hexane (100 mL), and then extracted with chloroform (100 mL) using a Soxhlet extractor. An obtained solution was condensed, then poured into methanol (200 mL) to precipitate a solid that was collected by filtration and dried under reduced pressure, obtaining the polymer block (B3) (0.35 g, 85%). The weight average molecular weight and the number average molecular weight of the obtained polymer block (B3) were each 33,000 and 15,000. The polydispersity thereof was 2.20.
¹H-NMR (270 MHz): δ = 7.05 - 6.95 (m, 5H), 2.80 (t, J = 8.0 Hz, 2H), 1.70 - 1.20 (m, 25H), 1.19 - 0.83 (m, 6H)

### [Example 1]

A block copolymer (1) was synthesized according to the reaction formula below.

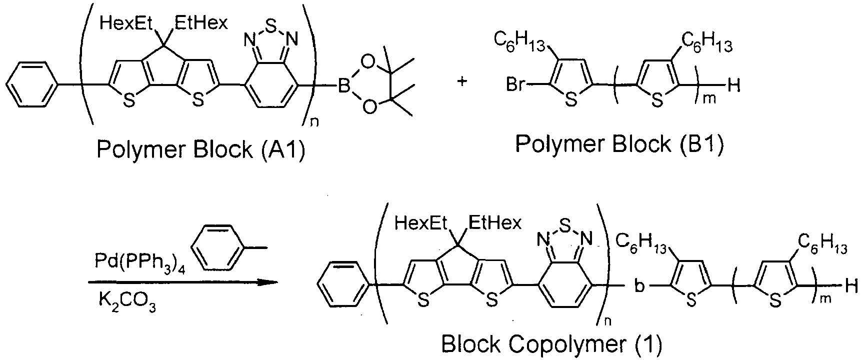

Under a nitrogen atmosphere, into a 100 mL three-necked flask, the polymer block (A1) (0.80 g, 1.50 mmol), the polymer block (B1) (0.25 g, 1.50 mmol), toluene (20 mL), 2M aqueous solution of potassium carbonate (10 mL, 20 mmol), tetrakis(triphenylphosphine)palladium(0) (20.5 mg, 17.7 µmol) and aliquat 336 (0.8 mg, 1.98 µmol) were added and stirred for 24 hours at 80°C. After completion of the reaction, the reacted solution was poured into methanol (200 mL). The precipitated solid was collected by filtration and washed with water (20 mL) and methanol (20 mL). The obtained solid was dried under reduced pressure, obtaining a crude product. The crude product was washed with acetone (100 mL) and hexane (100 mL), and thereafter extracted by chloroform (100 mL) using a Soxhlet extractor. The resulting solution was concentrated and poured into methanol (200 mL) to precipitate. The precipitated solid was collected by filtration, dried under reduced pressure, obtaining the block copolymer (1) (0.32 g, 31%) as a black purple solid. The weight average molecular weight (Mw) and the number average molecular weight (Mn) of the obtained block copolymer (1) were each 86,100 and 41,000. The polydispersity thereof was 2.10.
¹H-NMR (270 MHz): δ = 8.12 - 7.94 (m, 2H), 7.80 - 7.61 (m, 2H), 6.97 (s, 1H), 2.80 (t, J = 8.0 Hz, 2H), 2.35 - 2.12 (m, 4H), 1.62 - 1.31 (m, 26H), 1.19 - 0.83 (m, 15H)

### [Example 2]

A block copolymer (2) was synthesized according to the following reaction formula.

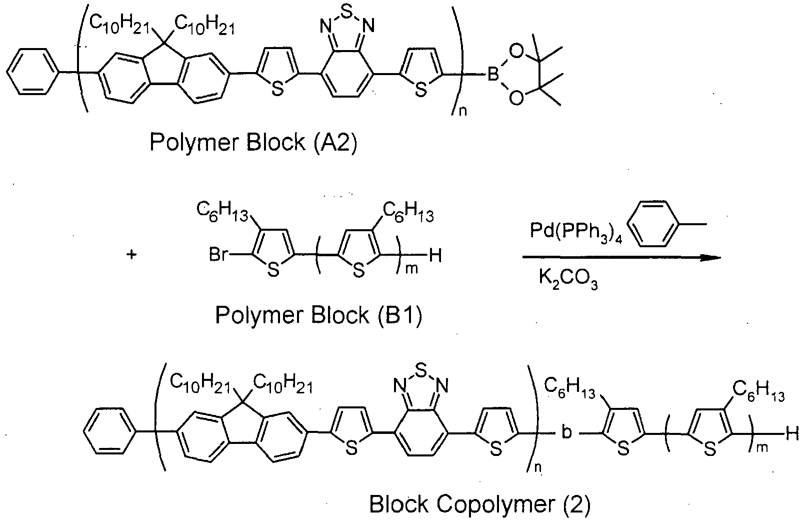

The block copolymer (2) (0.45 g, 33%) was obtained in the same manner as described in Example 1 except that the polymer block (A2) (1.11 g, 1.50 mmol) and the polymer block (B1) (0.25 g, 1.50 mmol) were used. The weight average molecular weight (Mw) and the number average molecular weight (Mn) of the block copolymer (2) were each 90,500 and 42,500. The polydispersity thereof was 2.13.
¹H-NMR (270 MHz): δ = 8.11 (d, J = 3.5 Hz, 2H), δ = 8.08 - 7.93 (m, 8H), 7.45 (d, J = 3.6 Hz, 2H), 6.97 (s, 1H), 3.70 - 3.60 (m, 2H), 2.86 - 2.72 (m, 4H), 2.33 - 2.12 (m, 4H), 1.70 - 1.32 (m, 38H), 1.19 - 0.82 (m, 9H)

### [Example 3]

A block copolymer (3) was synthesized according to the following reaction formula.

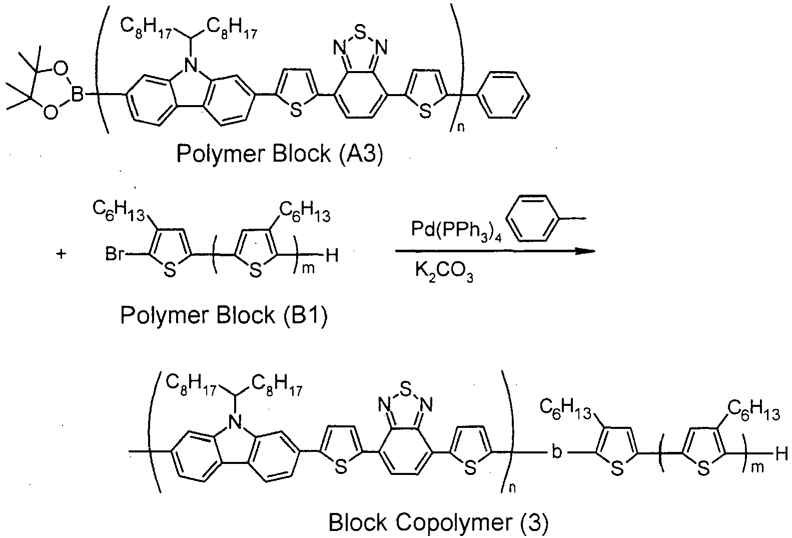

The block copolymer (3) (0.43 g, 33%) was obtained in the same manner as described in Example 1 except that the polymer block (A3) (1.05 g, 1.50 mmol) and the polymer block (B1) (0.25 g, 1.50 mmol) were used. The weight average molecular weight (Mw) and the number average molecular weight (Mn) of the block copolymer (3) were each 76,800 and 39,200. The polydispersity thereof was 1.96.
¹H-NMR (270 MHz): δ = 8.11 (d, J = 3.5 Hz, 2H), 8.02 (d, J = 7.0 Hz, 2H), 7.94 (m, 2H), 7.75 (m, 2H), 7.56 (d, J = 3.8 Hz, 2H), 7.45 (d, J = 3.5 Hz, 2H), 6.97 (s, 1H), 4.73 (m, 1H), 2.80 (t, J = 8.0 Hz, 2H), 2.42 (m, 2H), 2.05 - 1.20 (m, 20H), 1.20 - 0.84 (m, 9H)

### [Example 4]

A block polymer (4) was synthesized according to the following reaction formula.

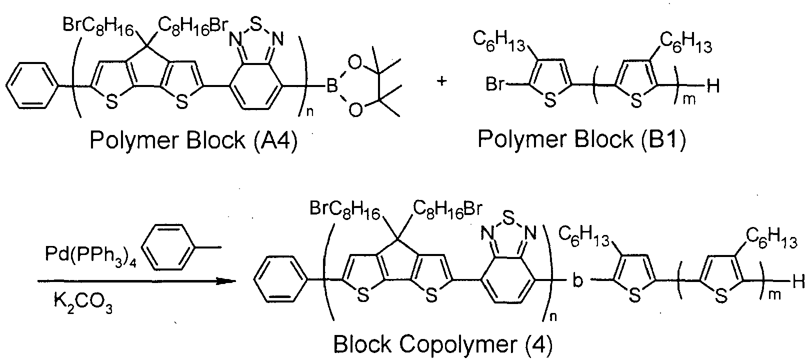

The block copolymer (4) (1.32 g, 32%) was obtained in the same manner as described in Example 1 except that polymer block (A4) (1.04 g, 1.50 mmol) and polymer block (B1) (0.25 g, 1.50 mmol) were used. The weight average molecular weight (Mw) and the number average molecular weight (Mn) of the obtained block copolymer (4) were each 83,600 and 39,800. The polydispersity thereof was 2.10.
¹H-NMR (270 MHz): δ = 8.13 - 7.98 (m, 2H), 7.90 - 7.12 (m, 2H), 6.97 (s, 1H), 3.17 - 2.97 (m, 4H), 2.80 (t, J = 8.0 Hz, 2H), 2.33 - 2.09 (m, 4H), 1.61 - 1.39 (m, 20H), 1.35 - 1.20 (m, 12H) 1.18 - 0.82 (m, 3H)

### [Example 5]

A block copolymer (1') was synthesized according to the following reaction formula.

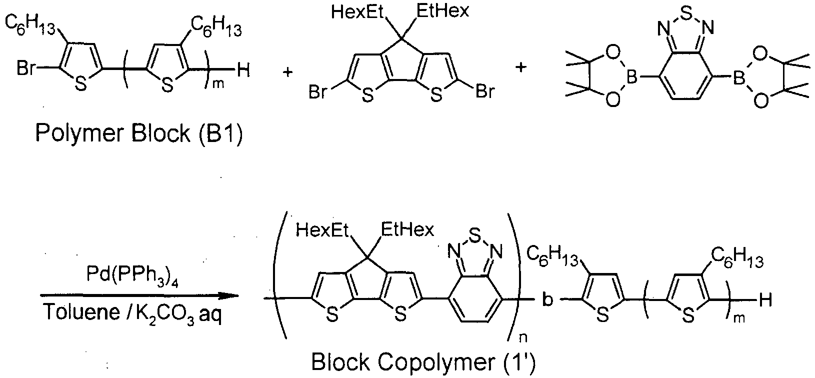

Under a nitrogen atmosphere, into a 100 mL three-necked flask, the polymer block (B1) (0.15 g, 0.90 mmol); and 4,7-bis(3,3,4,4-tetramethyl-2,5,1-dioxaborolane-1-yl)benzo[c][1,2,5]thiadiazole (0.35 g, 0.90 mmol) and 2,6-dibromo-4,4'-bis(2-ethylhexyl)cyclopenta[2,1-b:3,4-b']dithiophene (0.51 g, 0.90 mmol), which were monomers that would constitute the polymer block (A); were added. Further, toluene (17 mL), 2M aqueous solution of potassium carbonate (8.5 mL, 17 mmol), tetrakis(triphenylphosphine)palladium(O) (20.9 mg, 18.0 µmol) and aliquat 336 (0.8 mg, 1.98 µmol) were added. Then stirring was continued for 24 hours at 80°C. After completion of the reaction, the reacted solution was poured into methanol (200 mL). The precipitated solid was collected by filtration, washed with water (20 mL) and methanol (20 mL). The obtained solid was dried under a reduced pressure, obtaining a crude product. The crude product was washed with acetone (100 mL) and hexane (100 mL), and then extracted with chloroform (100 mL) using a Soxhlet extractor. The resulting solution was concentrated and then poured into methanol (200 mL). The precipitated solid was collected by filtration and then dried under reduced pressure, obtaining the block copolymer (1') (0.36 g, 75%) as a black purple solid. The weight average molecular weight (Mw) and the number average molecular weight (Mn) of the block copolymer (1') were each 78,800 and 33,700. The polydispersity thereof was 2.34.
¹H-NMR (270 MHz): δ = 8.20 - 8.12 (m, 2H), 8.00 - 7.80 (m, 2H), 6.97 (s, 1H), 2.91 - 2.72 (m, 2H), 1.62-1.31 (m, 26H), 1.19 - 0.83 (m, 15H), 2.80 (t, J = 8.0 Hz, 2H), 2.35 - 2.12 (m, 4H), 1.62-1.31 (m, 26H), 1.19 - 0.83 (m, 15H)

### [Example 6]

A block copolymer (5) was synthesized according to the following reaction formula.

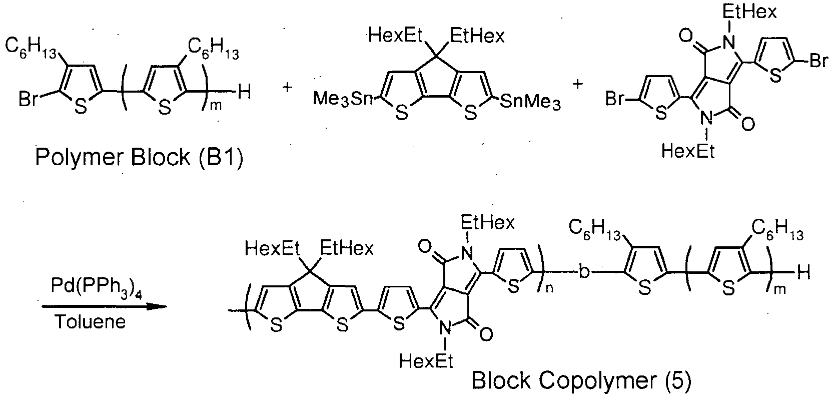

Under a nitrogen atmosphere, into a 100 mL three-necked flask, the polymer block (B1) (0.15 g, 0.9 mmol); and 3,6-bis(5-bromothiophene-2-yl)-2,5-bis(2-ethylhexyl)pyrrolo[3,4-c]pyrrole-1,4(2H,5H)-dione (0.61 g, 0.90 mmol) and 4,4'-bis(2-ethylhexyl)-2,6-bis(trimethyltin)cyclopenta[2,1-b:3,4-b']dithiophene (0.65 g, 0.90 mmol), which were monomers that would constitute the polymer block (A); were added, and further toluene (15 mL) was added. Next, tetrakis(triphenylphosphine)palladium(O) (35 mg, 31 µmol) was added. The mixture was heated for 16 hours at 115°C. After completion of the reaction, the reacted solution was poured into methanol (300 mL). The precipitated solid was collected by filtration and dried under reduced pressure to obtain a crude product. The crude product was washed with acetone (200 mL) and hexane (200 ml), and then extracted with chloroform (200 mL) using a Soxhlet extractor. The resulting organic layer was concentrated to dryness to yield a black purple solid, which was again dissolved in chloroform (30 mL) and reprecipitated with methanol (300 mL), obtaining the block copolymer (5) (0.58 g, 70%). The weight average molecular weight (Mw) and the number average molecular weight (Mn) of the obtained block copolymer (5) were each 86,400 and 43,200. The polydispersity thereof was 2.00.
¹H-NMR (270 MHz): δ = 8.91 - 8.77 (m, 2H), 7.21 - 7.02 (m, 4H), 6.97 (s, 1H), 4.15 - 4.05 (t, J = 8.0 Hz, 4H), 2.80 (t, J = 8.0 Hz, 2H), 2.35 - 2.11 (m, 4H), 1.61 - 1.34 (m, 44H), 1.18 - 0.60 (m, 27H)

### [Example 7]

A block copolymer (6) was synthesized according to the following reaction formula.

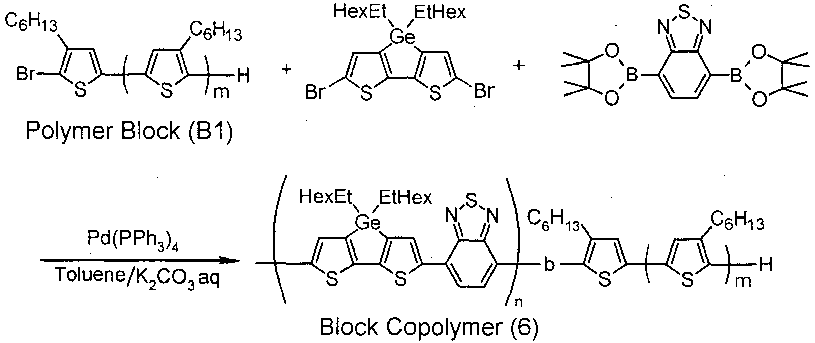

The block copolymer (6) (0.37 g, 69%) was obtained in the same manner as described in Example 5 except that under a nitrogen atmosphere, into a 100 mL three-necked flask, the polymer block (B1) (0.15 g, 0.90 mmol); and 4,7-bis(3,3,4,4-tetramethyl-2,5,1-dioxaborolane-1-yl)benzo[c][1,2,5]thiadiazole (0.35 g, 0.90 mmol) and 2,6-dibromo-4,4'-bis(2-ethylhexyl)dithieno[3,2-b:2',3'-d]germole (0.56 g, 0.90 mmol), which were monomers that would constitute the polymer block (A); were added. The weight average molecular weight and the number average molecular weight of the obtained block copolymer (6) were each 86,100 and 41,000. The polydispersity thereof was 2.10.
¹H-NMR (270 MHz): δ = 8.21 - 7.94 (m, 2H), 7.92 - 7.13 (m, 2H), 6.97 (s, 1H), 2.80 (t, J = 8.0 Hz, 2H), 2.35 - 2.11 (m, 4H), 1.61-1.31 (m, 32H), 1.19 - 0.83 (m, 15H)

### [Example 8]

A block copolymer (7) was synthesized according to the following reaction formula.

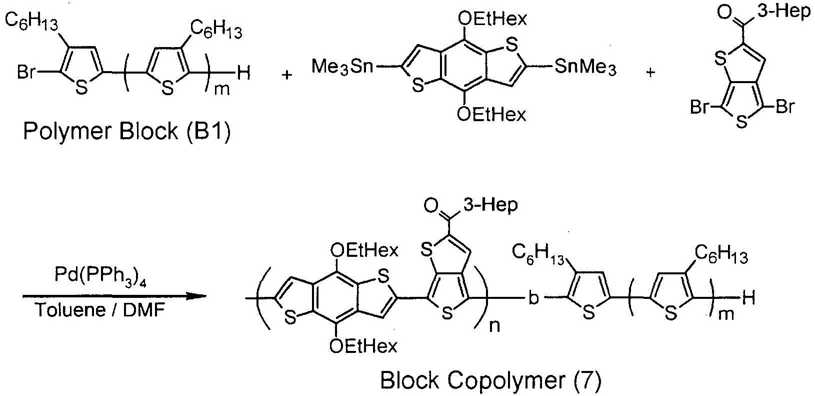

The block copolymer (7) (0.79 g, quant.) was obtained in the same manner as described in Example 6 except that under a nitrogen atmosphere, in a 50 mL flask, the polymer block (B1) (0.15 g, 0.90 mmol); 2,6-bis(trimethyltin)-4,8-bis(2-ethylhexyloxy)benzo[1,2-b:4,5-b']dithiophene (0.70 g, 0.90 mmol) and 1-(4,6-dibromothieno[3,4-b]thiophene-2-yl)-2-ethylhexane-1-on (0.38 g, 0.90 mmol), which were monomers that would constitute the polymer block (A); and DMF (3.8 mL) were used. The weight average molecular weight (Mw) and the number average molecular weight (Mn) of the obtained block copolymer (7) were each 219,000 and 37,000. The polydispersity thereof was 6.00.
¹H-NMR (270 MHz): δ = 7.60 - 7.30 (br, 3H), 6.97 (s, 1H), 4.30 - 4.00 (br, 4H), 3.20 - 3.00 (br, 1H), 2.80 (t, J = 8.0 Hz, 2H), 2.00 - 0.60 (br, 55H)

### [Example 9]

A block copolymer (8) was synthesized according to the following reaction formula.

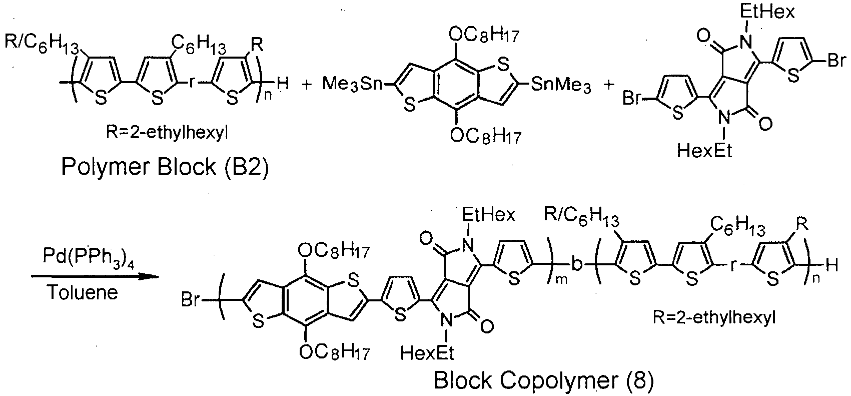

The block polymer (8) (0.56 g, 64%)was obtained in the same manner as described in Example 6 except that the polymer block (B2) (0.16 g, 0.90 mmol); and 2,6-bis(trimethyltin)-4,8-bis(octyloxy)benzo[1,2-b:4,5-b']dithiophene (0.70 g, 0.90 mmol) and 2,5-bis(2-ethylhexyl-3,6-di(5-bromothiophene-2-yl)pyrrolo[3,4-c]-2,5-dihydro-1,4-dion e (0.61 g, 0.90 mmol), which were monomers that would constitute the polymer block (A) were used. The weight average molecular weight (Mw) and the number average molecular weight (Mn) of the obtained block copolymer (8) were each 77,000 and 35,000. The polydispersity thereof was 2.20.
¹H-NMR (270 MHz): δ = 8.91 - 8.77 (m, 2H), 7.21 - 7.02 (m, 4H), 6.97 (s, 0.7H), 6.94 (s, 0.3H), 4.15 - 4.05 (t, J = 8.0 Hz, 4H), 2.80 (m, 2H), 2.35 - 2.11 (m, 4H), 1.70 - 1.25 (m, 44.3H), 1.18 - 0.60 (m, 27.9H)

### [Example 10]

A block copolymer (9) was synthesized according to the following reaction formula.

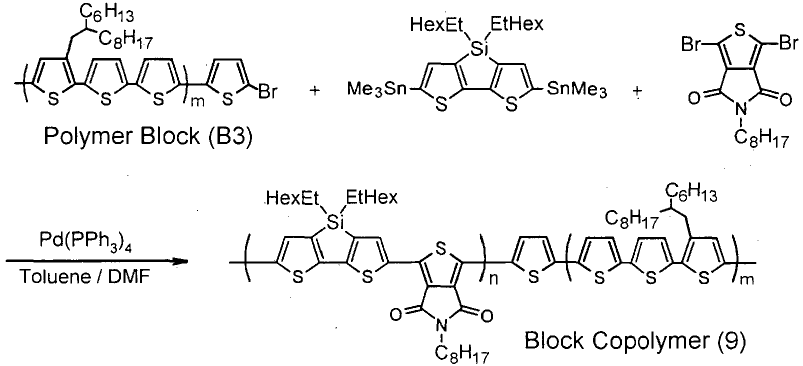

Under a nitrogen atmosphere, into a 100 mL flask, the polymer block (B3) (0.42 g, 0.90 mmol); and 3-dibromo-5-octylthieno[3,4-c]pyrrole-4,6-dione (0.38 g, 0.90 mmol) and 4,4-bis(2-ethylhexyl)-2,6-bis(trimethyltin)dithieno[3,2-b:2',3'-d']silole (0.67 g, 0.90 mmol), which were monomers that would constitute the polymer block (A); were added. DMF (3.8 mL), toluene (15 mL) and tetrakis(triphenylphosphine)palladium(O) (60 mg, 0.05 mmol) were further added and heated for 5 hours at 110°C. After completion of the reaction, the reacted solution was poured into methanol (300 mL). The resulting precipitated solid was collected by filtration and then dried under reduced pressure to obtain a crude product. After washed with acetone (200 mL), hexane (200 mL) and dichloromethane (200 mL), the crude product was extracted with chloroform (200 mL) using a Soxhlet extractor. The resulting solution was concentrated and then poured into methanol (300 mL). The precipitated solid was collected by filtration and dried under reduced pressure, obtaining the block copolymer (9) as a black purple solid (0.44 g, 73%). The weight average molecular weight (Mw) and the number average molecular weight (Mn) of the obtained block copolymer (9) were each 189,000 and 65,000. The polydispersity thereof was 2.90.
¹H-NMR (270 MHz): δ = 8.59 (s, 1H), 7.52 (s, 1H), 7.05 - 6.95 (m, 5H), 3.64 (br, 2H), 2.80 (t, J = 8.0 Hz, 2H), 2.10-1.20 (m, 55H), 1.19 - 0.60 (m, 6H)

### [Example 11]

A block copolymer (10) was synthesized according to the following reaction formula.

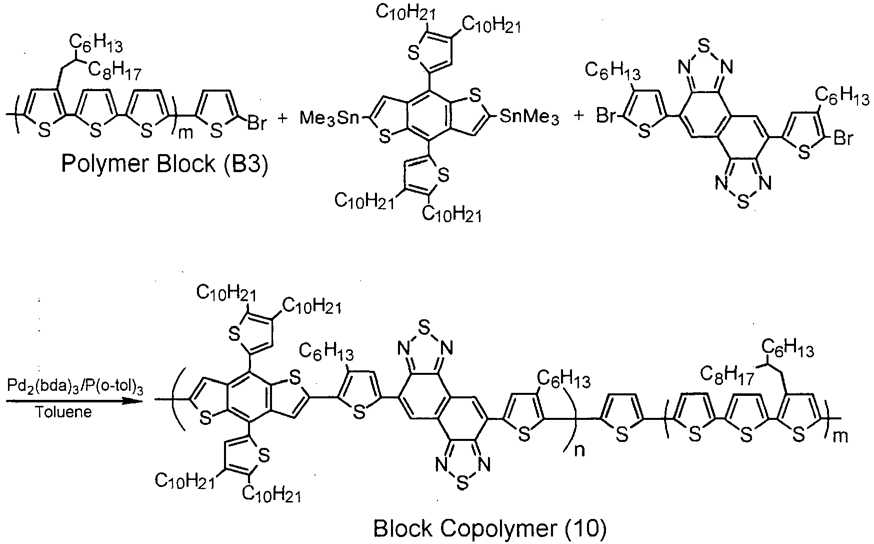

Under a nitrogen atmosphere, into a 50 mL flask, tris(o-tolyl)phosphine (63 mg, 0.17 mmol), tris(dibenzylideneacetone)dipalladium (25 mg, 28 µmol) and toluene (15 mL) were added and heated for 10 minutes at 50°C. After heating, let the temperature once cool down to room temperature. The polymer block (B3) (0.42 g, 0.90 mmol), and 3,7-di(2-bromo-3-hexylthiophene-5-yl)naphtho[1,2-c:5,6-c]bis[1,2,5]thiadiazole (0.66 g, 0.90 mmol) and 2,6-bis(trimethyltin)-4,8-di(2,3-didecylthiophene-5-yl)benzo[1,2-b:4,5-b']dithiophene (1.12 g, 0.90 mmol), which were monomers that would constitute the polymer block (A); were added. After argon gas was bubbled in the container for 20 minutes, the mixture was heated for 24 hours. After the reaction, using the same method as described in Polymerization Example 7, the block copolymer (10) (0.79 g, 59%) was obtained. The weight average molecular weight and the number average molecular weight of the obtained block copolymer (10) were each 232,000 and 61,000. The polydispersity thereof was 3.80.
¹H-NMR (270 MHz): δ = 7.94 (br, 2H), 7.84 - 7.82 (br, 2H), 7.51 (br, 2H), 7.33 (br, 2H), 7.05 - 6.95 (m, 5H), 2.80 (t, J = 8.0 Hz, 2H), 2.71 - 2.54 (br, 12H), 1:70 - 1.20 (m, 37H), 1.19 - 0.70 (m, 92H)

### [Preparation of a Mixed Solution of the Block Copolymer and the Electron Accepting Material]

The block copolymer (1) (16.0 mg) obtained in Example 1, PCBM (12.8 mg) (E100H, produced by Frontier Carbon Corporation.) as an electron accepting material and chlorobenzene (1 mL) as a solvent were mixed over 6 hours at 40°C. Then cooled to 20°C (room temperature) and then filtered through a PTFE filter with a pore size of 0.45 µm, obtaining a solution containing the block copolymer and PCBM. By the same method, a solution containing PCBM and each block copolymer obtained by Examples 2 to 11 was prepared.

### [Production of Organic Thin Film Solar Cell with a Layer of Block Copolymer Composition]

A glass substrate having an ITO film (resistance 10Ω / □) with a thickness of 150 nm provided by sputtering was subjected to a surface treatment by ozone UV treatment for 15 minutes. A layer that can be used as a hole transporting layer on the surface-treated substrate was deposited to a thickness of 40 nm by spin coating from PEDOT : PSS aqueous solution (CLEVIOS PH500 produced by H. C. Starck Inc.). After 20 minutes heating and drying at 140°C with a hot plate, a solution containing the PCBM and each block copolymer was spin coated to form an organic photoelectric conversion layer for organic thin film solar cell (thickness: about 100 nm). After vacuum drying for 3 hours and thermal annealing for 30 minutes at 120°C, by vacuum deposition, lithium fluoride was deposited to a thickness of 1 nm using a vacuum deposition device, and then Al was deposited to a film thickness of 100 nm. Thus, an organic thin film solar cell or a photoelectric conversion element having a layer formed from a composition comprising the block copolymer obtained in Examples 1 to 11 was obtained. Shape of the organic thin film solar cell was a square of 5 × 5 mm.

### [Comparative Examples 1-4 and 7-9]

A mixed solution was prepared in the same manner as described above by using the polymer block (A1) obtained in Polymerization Example 1 and an electron accepting material. By using this mixed solution, an organic thin film solar cell of Comparative Example 1 was produced.

In the same manner as described above, in Comparative Examples 2-4, organic thin film solar cells were fabricated by using each polymer block (A2) - (A4) obtained in Polymerization Examples 2-4, and in Comparative Examples 7-9, organic thin film solar cells were fabricated by using each polymer block (B1) - (B3) obtained in Polymerization Examples 5-7.

### [Comparative Example 5]

According to the method described in Example 6, and by performing the polymerization without addition of the polymer block (B1), an alternating copolymer made from 4,4'-bis(2-ethylhexyl)cyclopentadithiophene (CT) and 3,6-bis(thiophene-2-yl)-2,5-bis(2-ethylhexyl)diketopyrrolopyrrole (DPP) was synthesized. An organic thin-film solar cell of Comparative Example 5 was fabricated in the same manner as described above.

### [Comparative Example 6]

According to the method described in Example 7, and by performing the polymerization without addition of the polymer block (B1), an alternating copolymer made from 4,4'-bis(2-ethylhexyl)dithienogermole (GeT), and benzothiadiazole (BT) was synthesized. An organic thin film solar cell of Comparative example 6 was fabricated in the same manner as described above.

### [Comparative Example 10]

The polymer block (B1) (13 mg) and polymer block (A1) (3 mg) as a conjugated polymer, PCBM (E100H, produced by Frontier Carbon Corporation.) (16 mg) as an electron accepting material, and ortho-dichlorobenzene (1 mL) as a solvent were mixed over 6 hours at 40°C. Then the mixture was cooled to 20°C, room temperature, and was filtered through a PTFE filter with a pore size of 0.45 µm, obtaining a solution containing the conjugated polymer blend and PCBM. An organic thin film solar cell in Comparative Example 8 was fabricated by using this solution in the same manner as described above.

### [Comparative Example 11]

A diblock copolymer made from 3-butylthiophene and 3-octylthiophene (molar ratio of 1:1) was synthesized (Chem. Mater., 22, p.2020 (2010) (Non-Patent Document 8 listed)). A mixed solution with an electron accepting material was produced in the same manner as described above. By using this solution, an organic thin film solar cell of Comparative Example 9 was fabricated.

### [Comparative Example 12]

An alternating copolymer made from 4,8-bis(2-ethylhexyloxy)benzo[1,2-b:4,5-b']dithiophene and 1-(thieno[3,4-b]thiophene-2-yl)-2-ethyl-hexane-1-on was synthesized (detailed synthetic procedures of the diblock copolymer are described in J. Am. Chem. Soc., 131, p.15586 (2009) (Non-Patent Document 10)). An organic thin film solar cell of Comparative Example 10 was fabricated in the same manner as described in the Examples and Comparative Examples mentioned above.

### [Evaluation of Organic Thin Film Solar Cells]

Photoelectric conversion efficiencies of organic thin film solar cells of each Examples and Comparative Examples were measured using a 300 W Solar Simulator (produced by Peccell Technologies, Inc., trade name: PEC L11 : AM1.5G filter, irradiance 100 mW/cm²). Measurement results are shown in Tables 1-4.

**Table 1**

| | Block Copolymer | Polymer Block (A) | Polymer Block (B) | Photoelectric Conversion Efficiency (%) |
|---|---|---|---|---|
| Ex.1 | Block Copolymer (1) | 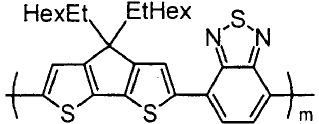 | 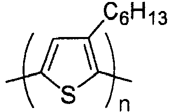 | 3.6 |
| Ex.2 | Block Copolymer (2) | 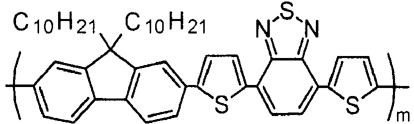 | 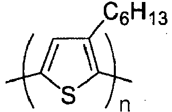 | 3.1 |
| Ex.3 | Block Copolymer (3) | 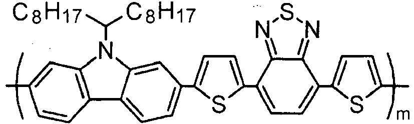 | 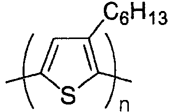 | 3.2 |
| Ex.4 | Block Copolymer (4) | 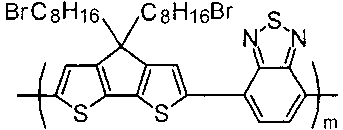 | 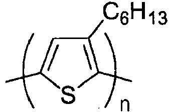 | 3.6 |
| Ex.5 | Block Copolymer (1,) | 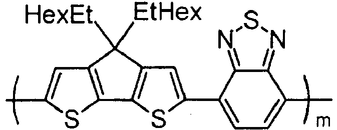 | 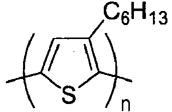 | 3.7 |

**Table 2**

| | Block Copolymer | Polymer Block (A) | Polymer Block (B) | Photoelectric Conversion Efficiency (%) |
|---|---|---|---|---|
| Ex.6 | Block Copolymer (5) | 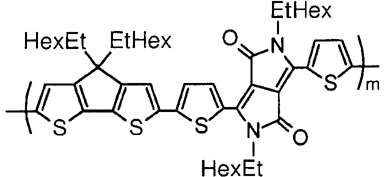 | 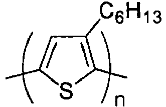 | 3.4 |
| Ex.7 | Block Copolymer (6) | 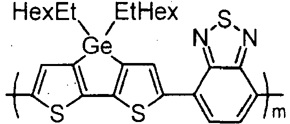 | 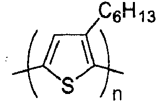 | 3.6 |
| Ex.8 | Block Copolymer (7) | 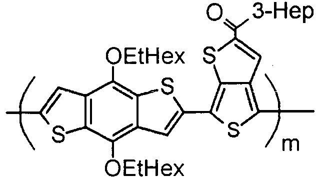 | 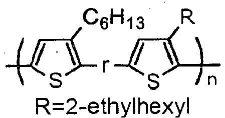 | 4.5 |
| Ex.9 | Block Copolymer (8) | 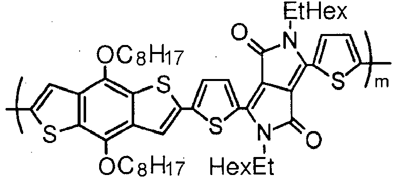 | 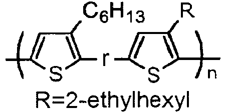 | 3.8 |
| Ex.10 | Block Copolymer (9) | 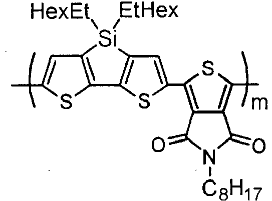 | 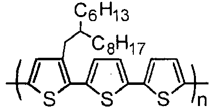 | 4.3 |
| Ex.11 | Block Copolymer (10) | 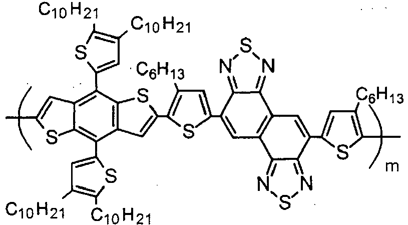 | 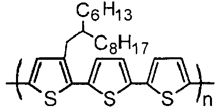 | 4.3 |

**Table 3**

| | Conjugated Polymer | Polymer Block (A) | Polymer Block (B) | Photoelectric Conversion Efficiency (%) |
|---|---|---|---|---|
| Comp. Ex.1 | Polymer Block (A1) | 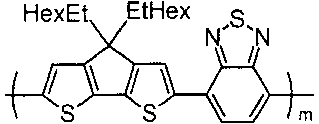 | - | 2.7 |
| Comp. Ex.2 | Polymer Block (A2) | 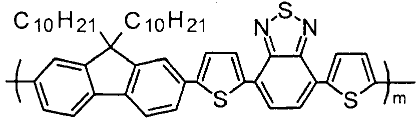 | - | 2.3 |
| Comp. Ex.3 3 | Polymer Block (A3) | 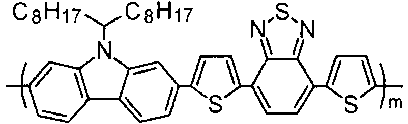 | - | 2.1 |
| Comp. Ex.4 | Polymer Block (A4) | 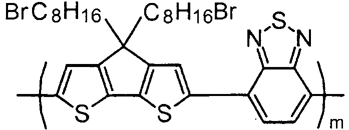 | - | 2.7 |
| Comp. Ex.5 | CT-DPP Alternating Copolymer | 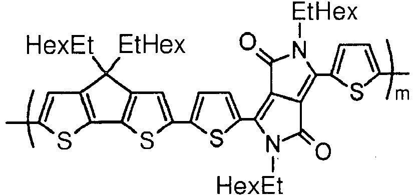 | - | 1.2 |

**Table 4**

| | Conjugated Polymer | Polymer Block (A) | Polymer Block (B) | Photoelectric Conversion Efficiency (%) |
|---|---|---|---|---|
| Comp. Ex.6 | Get-BT Alternating Copolymer | 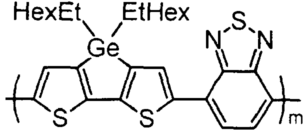 | - | 2.8 |
| Comp. Ex.7 | Polymer Block (B1) | - | 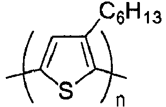 | 2.4 |
| Comp. Ex.8 | Polymer Block (B2) | - | 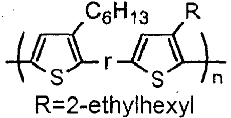 | 2.3 |
| Comp. Ex.9 9 | Polymer Block (B3) | - | 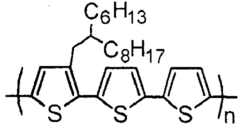 | 3.0 |
| Comp. Ex.10* | Mixture of Polymer Block (A1) and Polymer Block (B1) | 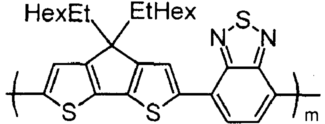 | 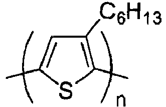 | 2.8 |
| Comp. Ex.11 | Polymer Described in Non-Patent Document 8 | 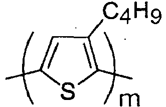 | 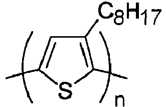 | 3.0 |
| Comp. Ex.12 | Polymer Described in Non-Patent Document 10 | 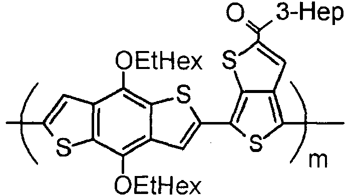 | - | 3.0 |

| | | | | |
|---|---|---|---|---|
| * : mixture of two types of polymers, it is not a block copolymer of the present invention. | | | | |

As clearly seen from Tables 1 - 4, the organic thin film solar cells made of the π-electron conjugated block copolymer of Examples have higher photoelectric conversion efficiencies when compared to the organic thin film solar cells made of conjugated polymers or π-electron conjugated block copolymers of Comparative Examples.

### INDUSTRIAL APPLICABILITY

The novel π-electron conjugated block copolymers of the present invention can be utilized as the photoelectric conversion layers for the photoelectric conversion elements. The photoelectric conversion element made of the copolymers can be used for optical sensors of various types as well as solar cells.

## Claims

1. A π-electron conjugated block copolymer comprising:
a polymer block (A) which involving a monomer unit having at least one heteroaryl skeleton selected from the group consisting of a fused π-conjugated skeleton, a fluorene, a carbazole, a dibenzosilole and a dibenzogermole containing at least one thiophene ring in a part of a chemical structure thereof; and
a polymer block (B) involving a monomer unit of a thiophene-2,5-diyl group having a substituent at least at a 3-position thereof.

2. The π-electron conjugated block copolymer according to Claim 1,
wherein the polymer block (A) includes a monomer unit of -a-b-, -a- has any one of groups represented by the following formulas (1) - (6), 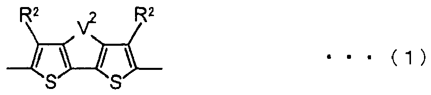 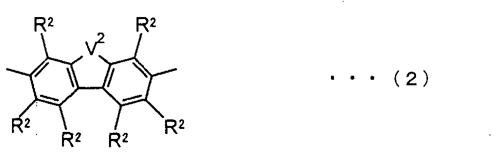 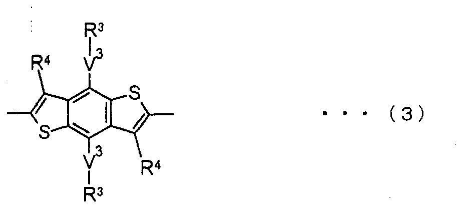 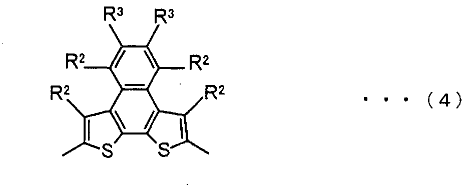 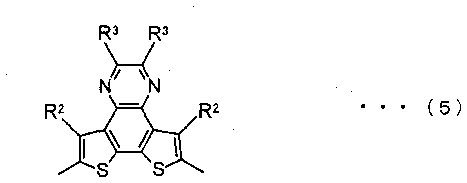 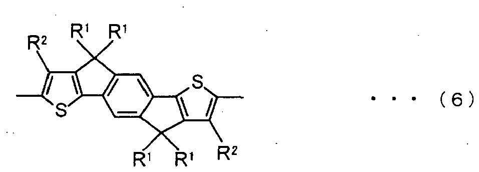 and -b- is a monomer unit having any one of groups represented by the following formulas (7) - (17) 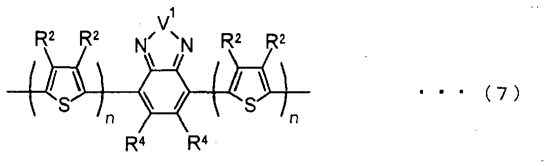 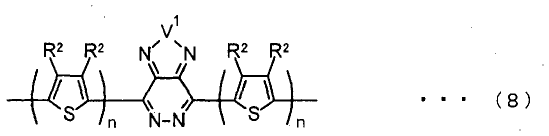 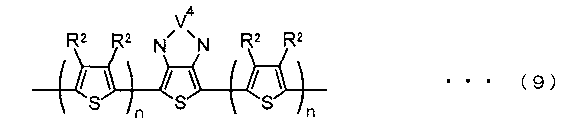 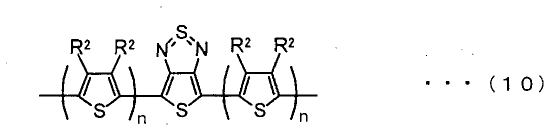 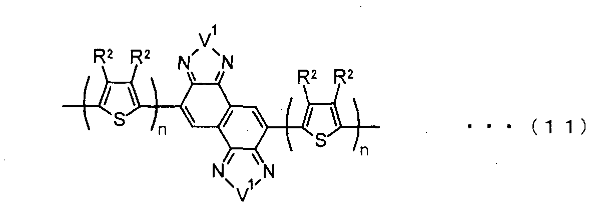 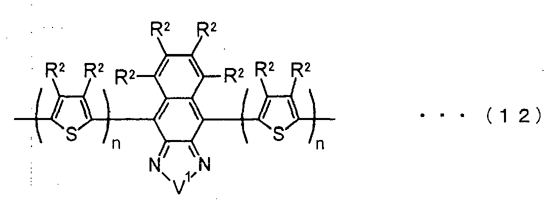 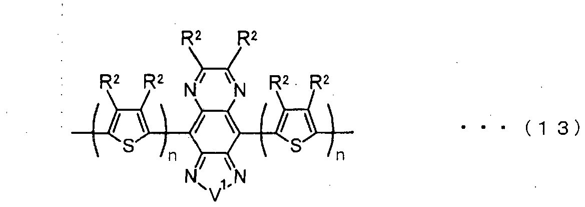 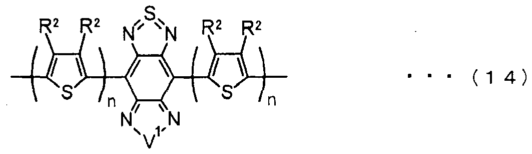 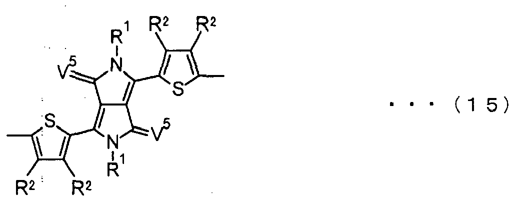 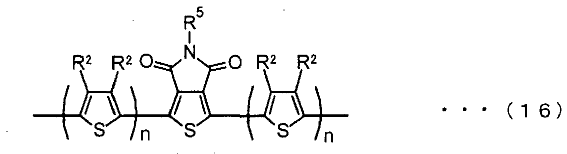 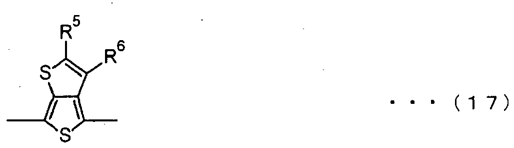 in the above formulas (1) - (17), V¹ is a nitrogen (-NR¹-), oxygen (-O-) or sulfur (-S-); V² is a carbon (-CR¹₂-), nitrogen (-NR¹-), silicon (-SiR¹₂-) or germanium (-GeR¹₂-); V³ is an aryl or heteroaryl group represented by -(Ar)ₙ-; V⁴ is a nitrogen (-NR¹-), oxygen (-O-) or -CR²=CR²-; V⁵ is an oxygen (O) or sulfur (S):
R¹ is an alkyl group having 1-18 carbon atoms which may be each independently substituted; R² is a hydrogen atom or an alkyl group having 1-18 carbon atoms which may be each independently substituted; R³ is an alkoxy group or an alkyl group having 1 - 18 carbon atoms which may be each independently substituted; R⁴ is a hydrogen atom, a halogen atom, an aryl group or an alkyl group having 1-18 carbon atoms which may be each independently substituted; R⁵ is an aryl group, an alkylcarbonyl group, an alkyloxycarbonyl group or an alkyl group having 1-18 carbon atoms which may be substituted, and R⁶ is a hydrogen atom or a halogen atom:
n represents an integer of 0 - 3.

3. The π-electron conjugated block copolymer according to Claim 2,
wherein the monomer unit -a-b- is any one selected from the following formulas (18) - (28) 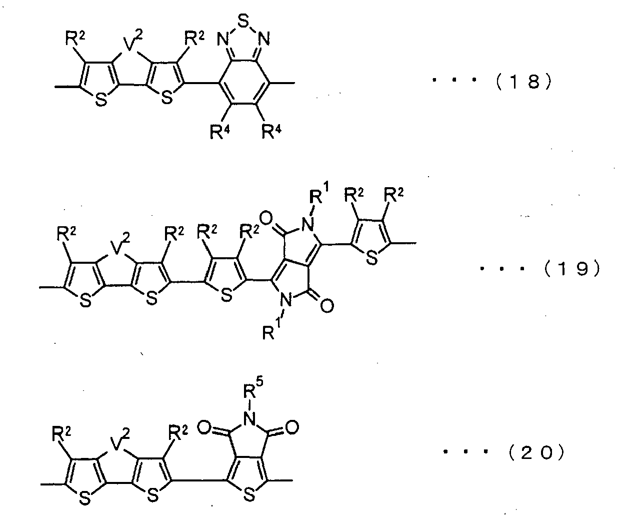 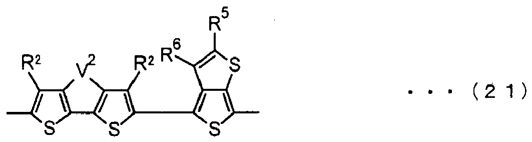 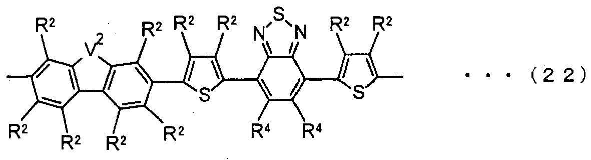 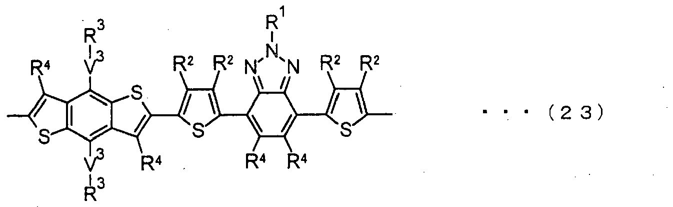 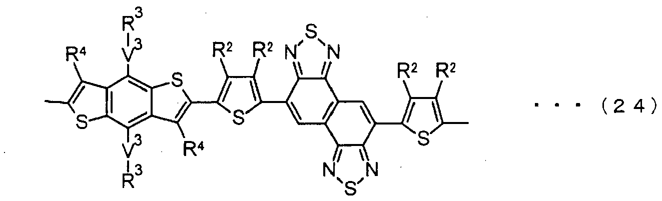 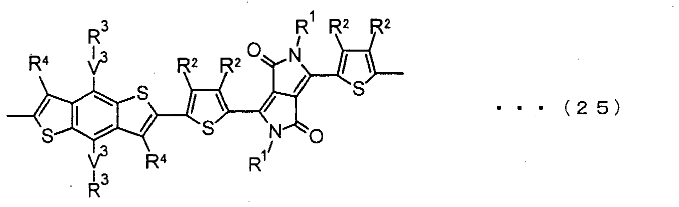 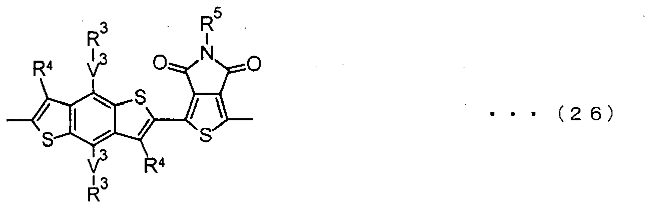 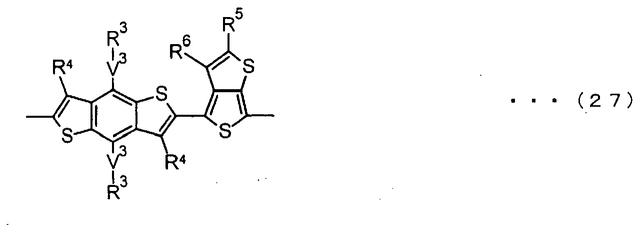 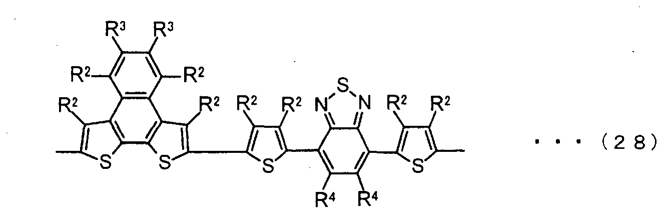 in the above formulas (18) - (28), V² is a carbon (-CR¹₂-), nitrogen (-NR¹-), silicon (-SiR¹₂-) or germanium (-GeR¹₂-); V³ is an aryl or heteroaryl group represented by -(Ar)ₙ-:
R¹, R², R³, R⁴, R⁵ and R⁶ are the same meanings as defined above:
n represents an integer of 0-3.

4. The π-electron conjugated block copolymer according to Claim 1,
wherein the polymer block (B) includes a monomer unit bonding 2 to 5 of thiophene-2,5-diyl groups having a substituent at least at the 3-position thereof.

5. The π-electron conjugated block copolymer according to Claim 1,
wherein the polymer block (B) is a random copolymer block having a plural types of thiophene-2,5-diyl groups having a substituent at least at the 3-position thereof.

6. The π-electron conjugated block copolymer according to any one of Claims 1-5.
wherein a number average molecular weight thereof is in the range of 1,000 - 200,000 g/mol.

7. A composition comprising an electron accepting material and the π-electron conjugated block copolymer according to any one of Claims 1-6.

8. A photoelectric conversion element comprising a layer consisting essentially of the composition according to Claim 7.

9. The photoelectric conversion element according to Claim 8,
wherein the electron accepting material is a fullerene or/and a derivative thereof.
